# EUROPEAN PATENT APPLICATION

(11) **EP 4 312 268 A1**
(43) Date of publication of application: **31.01.2024**
(21) Application number: 23174426.9
(22) Date of filing: 22.05.2023
(51) Int. Cl.: H01L 25/075, H01L 25/16, H01L 27/15

(54) **SEMICONDUCTOR DEVICE, METHOD OF MANUFACTURING THE SAME, AND LED DISPLAY DEVICE**

(30) Priority: 24.06.2022 JP 2022101843
(71) Applicant: Oki Electric Industry Co., Ltd., Minato-ku Tokyo 105-8460 (JP)
(72) Inventor: IINO, Akihiro, Tokyo, 105-8460 (JP); KOSAKA, Toru, Tokyo, 105-8460 (JP); FURUTA, Hironori, Tokyo, 105-8460 (JP); MATSUO, Genichirou, Tokyo, 105-8460 (JP); JUMONJI, Shinya, Tokyo, 105-8460 (JP); KAWADA, Hiroto, Tokyo, 105-8460 (JP); SHINOHARA, Yuuki, Tokyo, 105-8460 (JP)
(74) Representative: Betten & Resch

(57) **Abstract**

A semiconductor device includes: a planarized layer having insulating properties, the planarized layer having a first surface and a second surface opposite the first surface; a plurality of semiconductor elements formed on the first surface of the planarized layer; and a groove provided in the second surface of the planarized layer. The groove is formed in a region outside the plurality of semiconductor elements as viewed in a direction perpendicular to the first surface.

## Description

### BACKGROUND OF THE INVENTION

### 1. FIELD OF THE INVENTION

The present disclosure relates to a semiconductor device, a method of manufacturing the same, and an LED display device, and is preferably applied to, for example, a light emitting device in which semiconductor elements are mounted on a circuit substrate.

### 2. DESCRIPTION OF THE RELATED ART

There have been recently proposed semiconductor devices that are light emitting devices that display images by selectively driving multiple semiconductor elements arranged in matrixes on circuit substrates to cause them to emit light (see, e.g., Japanese Patent Application Publication No. 2022-23263). In such semiconductor devices, there is a semiconductor device in which a bonding object that is a film-shaped member including a semiconductor element that is a light emitting element is stacked on a bonded object that is a substrate or the like in a direction perpendicular to a light emitting surface of the light emitting element.

In such a semiconductor device, when the bonding object is bonded to the bonded object after the bonding object is produced, air bubbles may occur, preventing the bonding object from being transferred onto the bonded object with high positional accuracy.

### SUMMARY OF THE INVENTION

An object of the present disclosure is to provide a semiconductor device, a method of manufacturing the same, and an LED display device that are capable of improving positional accuracy.

According to an aspect of the present disclosure, there is provided a semiconductor device including: a planarized layer having insulating properties, the planarized layer having a first surface and a second surface opposite the first surface; a plurality of semiconductor elements formed on the first surface of the planarized layer; and a groove provided in the second surface of the planarized layer, wherein the groove is formed in a region outside the plurality of semiconductor elements as viewed in a first direction perpendicular to the first surface.

According to another aspect of the present disclosure, there is provided a method of manufacturing a semiconductor device, the method including: forming, on a formation substrate, a sacrificial layer having a projection in a surface of the sacrificial layer opposite a surface of the sacrificial layer in contact with the formation substrate; forming, on the sacrificial layer, a planarized layer having insulating properties, the planarized layer having a first surface and a second surface opposite the first surface; forming, on the first surface of the planarized layer, a plurality of semiconductor elements; and forming a groove in the second surface of the planarized layer by removing the sacrificial layer, wherein the projection is located in a region outside the plurality of semiconductor elements as viewed in a direction perpendicular to the first surface.

### BRIEF DESCRIPTION OF THE DRAWINGS

In the attached drawings:
FIG. 1 is a perspective view illustrating a configuration of an LED display device;
FIG. 2 illustrates a configuration of an LED display portion of a first embodiment, and is an enlarged plan view of portion A, which is an area including several pixels, in FIG. 1;
FIG. 3 illustrates a configuration of a circuit substrate of the first embodiment, and is an enlarged plan view obtained by omitting a thin-film layer group from FIG. 2;
FIG. 4 illustrates a configuration of a pixel portion and part of adjacent pixel portions of the first embodiment, and is a cross-sectional view taken along line A-A of FIG. 2;
FIG. 5 illustrates the configuration of the pixel portion and part of the adjacent pixel portions of the first embodiment, and is a cross-sectional view taken along line B-8 of FIG. 2;
FIG. 6 is a plan view illustrating a configuration of a first thin-film layer of the first embodiment;
FIG. 7 is a plan view illustrating a configuration of a second thin-film layer of the first embodiment;
FIG. 8 is a plan view illustrating a configuration of a third thin-film layer of the first embodiment;
FIGs. 9A to 9F illustrate a process of manufacturing the first thin-film layer of the first embodiment, and correspond to a cross-section taken along line C-C of FIG. 6;
FIGs. 10A to 10C illustrate a process of manufacturing the LED display portion of the first embodiment, and correspond to a cross-section taken along line A-A of FIG. 2;
FIG. 11 illustrates a configuration of an LED display portion of a second embodiment, and is an enlarged plan view of portion A, which is an area including several pixels, in FIG. 1;
FIG. 12 illustrates a configuration of a pixel portion and part of adjacent pixel portions of the second embodiment, and is a cross-sectional view taken along line A-A of FIG. 11;
FIG. 13 illustrates the configuration of the pixel portion and part of the adjacent pixel portions of the second embodiment, and is a cross-sectional view taken along line B-B of FIG. 11;
FIG. 14 is a plan view illustrating a configuration of a first thin-film layer of the second embodiment;
FIG. 15 is a plan view illustrating a configuration of a second thin-film layer of the second embodiment;
FIG. 16 is a plan view illustrating a configuration of a third thin-film layer of the second embodiment;
FIG. 17 is a plan view illustrating a configuration of a thin-film layer of a third embodiment;
FIG. 18 illustrates a configuration of a pixel portion of the third embodiment and a configuration of part of pixel portions adjacent to the pixel portion, and is a cross-sectional view taken along line D-D of FIG. 17;
FIG. 19 is a plan view illustrating a configuration of a thin-film layer of a fourth embodiment;
FIG. 20 illustrates a configuration of a pixel portion of the fourth embodiment and a configuration of part of pixel portions adjacent to the pixel portion, and is a cross-sectional view taken along line E-E of FIG. 19;
FIG. 21 is a plan view illustrating a configuration of an air passage groove of another embodiment;
FIG. 22 is a plan view illustrating a configuration of an air passage groove of another embodiment;
FIG. 23 is a plan view illustrating a configuration of an air passage groove of another embodiment;
FIG. 24 is a plan view illustrating a configuration of an air passage groove of another embodiment;
FIG. 25 is a plan view illustrating a configuration of an air passage groove of another embodiment; and
FIG. 26 is a plan view illustrating a configuration of an LED display device of another embodiment.

### DETAILED DESCRIPTION OF THE INVENTION

Embodiments of the present disclosure will be described below with reference to the drawings.

### <1. First embodiment>

### <1-1. Configuration of LED display device>

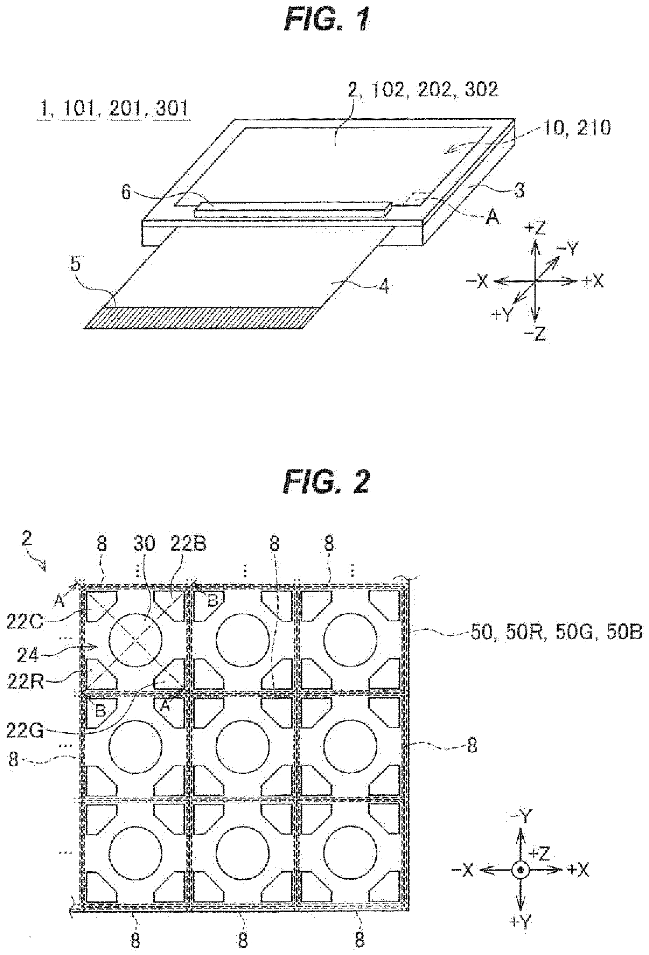

As illustrated in FIGs. 1 and 2, a light emitting diode (LED) display device 1 includes an LED display portion 2, a heat dissipator 3, a connection cable 4, a connection terminal portion 5, a driver 6, and the like. The LED display device 1, which is also referred to as a micro-LED display, is a display device in which a set of red, green, and blue LED elements corresponds to one pixel. Specifically, the LED display portion 2 is a display device in which elements each including inorganic LEDs are arranged in a matrix (or grid) on a circuit substrate (or board) 10 that is an active matrix circuit substrate, each element serving as one pixel. The circuit substrate 10 is a substrate in which a wiring layer and driving elements or driving circuitry connected to the wiring layer are disposed, and that provides electrical connection with the LEDs to selectively drive the LEDs in the pixels. Hereinafter, the rightward direction on the drawing sheet of FIG. 1 is taken as a +X direction, the leftward direction on the drawing sheet is taken as a -X direction, the leftward and downward direction on the drawing sheet is taken as a +Y direction, the rightward and upward direction is taken as a -Y direction, the upward direction on the drawing sheet is taken as a +Z direction, and the downward direction on the drawing sheet is taken as a -Z direction.

### <1-2. Entire configuration of LED display portion>

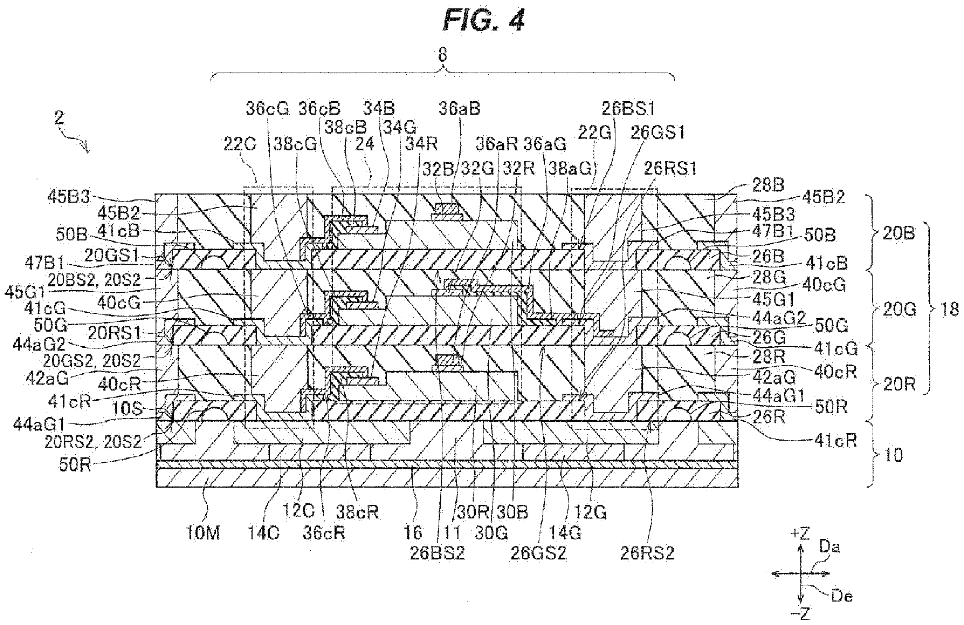

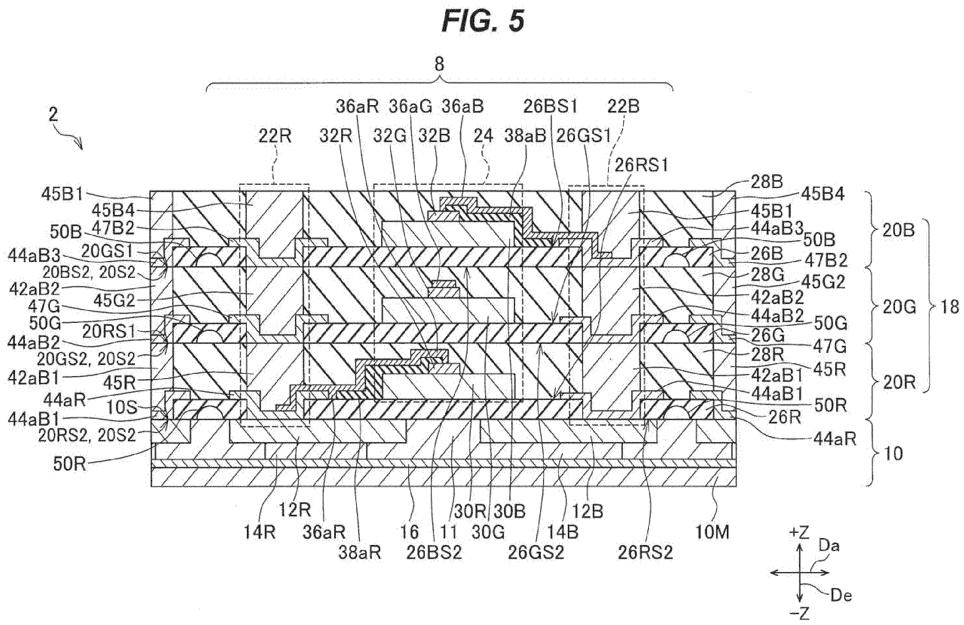

As illustrated in FIGs. 4 and 5, the LED display portion 2 has a configuration in which a thin-film layer group 18 constituted by three thin-film layers, a first thin-film layer 20R, a second thin-film layer 20G, and a third thin-film layer 20B, is stacked on a surface (hereinafter also referred to as a substrate surface 10S) of the circuit substrate 10, which has a flat plate shape and serves as a control substrate, on the +Z direction side, in a display region set in the substrate surface 10S. The first thin-film layer 20R serves as a first layer, the second thin-film layer 20G serves as a second layer, and the third thin-film layer 20B serves as a third layer. Hereinafter, the first thin-film layer 20R, second thin-film layer 20G, and third thin-film layer 20B may also be referred to collectively as thin-film layers 20. Each thin-film layer 20 is a film with light emitting elements arranged in a matrix, and the size of each thin-film layer 20 is the same as a display size of the LED display portion 2, i.e., the size of the display region, which includes all the pixels of the LED display portion 2. Thus, in the LED display portion 2, each thin-film layer 20 is not separated for each pixel, but instead has the same size as the entire display region and covers the entire display region.

The heat dissipator 3 (see FIG. 1) is formed by a metal material, such as aluminum, having relatively high thermal conductivity, and generally has a flat rectangular parallelepiped shape. The heat dissipator 3 is disposed in contact with the LED display portion 2 on the -Z direction side of the LED display portion 2, i.e., on a side opposite a surface on which an image or the like is displayed, thereby dissipating heat from the circuit substrate 10. The connection cable 4 is electrically connected to a predetermined control device (not illustrated) through the connection terminal portion 5, and transmits an image signal supplied from the control device and supplies it to the driver 6.

The driver 6 is, for example, mounted on a surface of the circuit substrate 10, and is electrically connected to each of the connection cable 4 and LED display portion 2. The driver 6 generates drive signals, specifically gate drive signals for the circuit substrate 10, for respective colors of red, green, and blue on the basis of, for example, the image signal supplied through the connection cable 4, and supplies the LED display portion 2 with drive currents based on the drive signals. Thus, the LED display device 1 displays an image based on the image signal supplied from the control device (not illustrated) or the like, in the display region of the LED display portion 2.

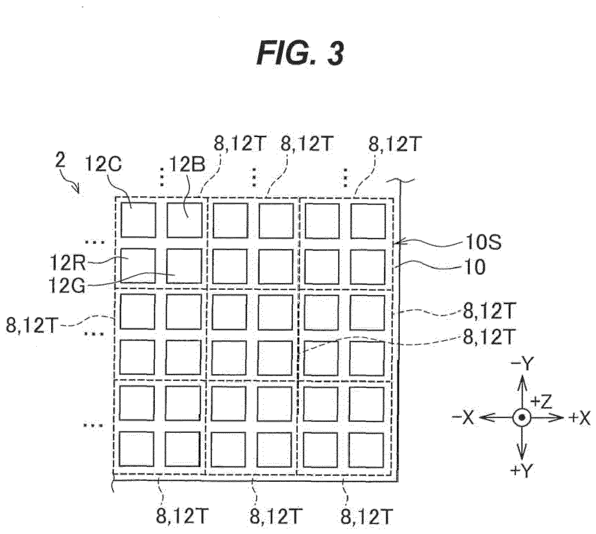

As illustrated in FIGs. 2 and 3, the LED display portion 2 includes multiple pixel portions 8 each corresponding to one pixel. The following describes the circuit substrate 10 and thin-film layer group 18 of the LED display portion 2, focusing on one pixel or one pixel portion 8 as appropriate. Also, hereinafter, reference characters for elements pertaining to cathode terminals have a suffix "C", reference characters for elements pertaining to a thin-film LED 30R of the first thin-film layer 20R have a suffix "R", reference characters for elements pertaining to a thin-film LED 30G of the second thin-film layer 20G have a suffix "G", and reference characters for elements pertaining to a thin-film LED 30B of the third thin-film layer 20B have a suffix "B". A direction (or the Z direction) perpendicular to an upper surface that is a surface of a base layer 26R of the first thin-film layer 20R on the +Z direction side may also be referred to as a light emitting direction De. A direction (or the Z direction) in which the first thin-film layer 20R, second thin-film layer 20G, and third thin-film layer 20B are stacked may also be referred to as a stacking direction. The left-right direction on the drawing sheet of FIG. 4, which is a direction along a cross-section taken along line A-A of FIG. 2, may also be referred to as an AA cross-section direction Da. The left-right direction on the drawing sheet of FIG. 5, which is a direction along a cross-section taken along line B-B of FIG. 2, may also be referred to as a BB cross-section direction Db.

### <1-3. Configuration of circuit substrate>

As illustrated in FIGs. 3, 4, and 5, the circuit substrate 10 is a complementary metal oxide semiconductor (CMOS) backplane circuit board manufactured by a silicon process. The circuit substrate 10 includes a substrate 10M, an insulating layer 11, circuit connection pads 12R, 12G, 12B, and 12C, active elements 14R, 14G, 14B, and 14C, and a wiring layer 16.

The substrate 10M is a silicon wafer. The insulating layer 11 has sufficient insulating properties, and is disposed to cover the wiring layer 16 from the +Z direction side.

The circuit connection pads 12R, 12G, 12B, and 12C are arranged in a matrix (or grid) in the substrate surface 10S. Hereinafter, the circuit connection pads 12R, 12G, 12B, and 12C may also be referred to collectively as circuit connection pads 12. The four circuit connection pads 12R, 12G, 12B, and 12C correspond to one pixel, and constitute a circuit connection pad set 12T. The circuit connection pad set 12T is disposed so that a light emitting portion 24 (see FIG. 2) is located inside a circumscribed rectangle of the circuit connection pads 12R, 12G, 12B, and 12C (i.e., in a pixel area).

The circuit connection pad 12R is formed by a conductive material, such as gold, copper, aluminum, or indium tin oxide. The circuit connection pad 12R has, for example, a square shape as viewed from the +Z direction side. The circuit connection pad 12R is located on the -X and +Y direction side of the circuit connection pad set 12T. The circuit connection pad 12R is located on the -Z direction side of an anode pad 44aR of a vertical wiring 22R. A surface (or an upper surface) of the circuit connection pad 12R on the +Z direction side is exposed in the substrate surface 10S. The circuit connection pad 12R is electrically connected to the active element 14R in the circuit substrate 10. The surface (or upper surface) of the circuit connection pad 12R on the +Z direction side is in contact with and electrically connected to a surface (or a lower surface) of the anode pad 44aR on the -Z direction side in the first thin-film layer 20R. Hereinafter, surfaces on the +Z direction side may also be referred to as upper surfaces, and surfaces on the -Z direction side may also be referred to as lower surfaces.

The circuit connection pad 12G is formed in the same manner as the circuit connection pad 12R. The circuit connection pad 12G is located on the +X and +Y direction side of the circuit connection pad set 12T. The circuit connection pad 12G is located on the -Z direction side of an anode pad 44aG1 of a vertical wiring 22G. An upper surface of the circuit connection pad 12G is exposed in the substrate surface 10S. The circuit connection pad 12G is electrically connected to the active element 14G in the circuit substrate 10. The upper surface of the circuit connection pad 12G is in contact with and electrically connected to a lower surface of the anode pad 44aG1 in the first thin-film layer 20R.

The circuit connection pad 12B is formed in the same manner as the circuit connection pad 12R. The circuit connection pad 12B is located on the +X and -Y direction side of the circuit connection pad set 12T. The circuit connection pad 12B is located on the -Z direction side of an anode pad 44aB1 of a vertical wiring 22B. An upper surface of the circuit connection pad 12B is exposed in the substrate surface 10S. The circuit connection pad 12B is electrically connected to the active element 14B in the circuit substrate 10. The upper surface of the circuit connection pad 12B is in contact with and electrically connected to a lower surface of the anode pad 44aB1 in the first thin-film layer 20R.

The circuit connection pad 12C is formed in the same manner as the circuit connection pad 12R. The circuit connection pad 12C is located on the -X and -Y direction side of the circuit connection pad set 12T. The circuit connection pad 12C is located on the -Z direction side of a cathode pad 41cR of a vertical wiring 22C. An upper surface of the circuit connection pad 12C is exposed in the substrate surface 10S. The circuit connection pad 12C is electrically connected through the active element 14C to a cathode common wiring of the wiring layer 16 in the circuit substrate 10. The upper surface of the circuit connection pad 12C is in contact with and electrically connected to a lower surface of the cathode pad 41cR in the first thin-film layer 20R.

The active elements 14R, 14G, 14B, and 14C are arranged in a matrix (or grid) inside the circuit substrate 10. Hereinafter, the active elements 14R, 14G, 14B, and 14C may also be referred to collectively as active elements 14.

The active element 14R is constituted by one or more thin film transistors and one or more capacitors, e.g., two metal oxide semiconductor (MOS) transistors and one capacitor. The active element 14R is located on the -Z direction side of the circuit connection pad 12R, and is electrically connected to wiring in the wiring layer 16. The active elements 14G and 14B are configured in the same manner as the active element 14R. The active elements 14G and 14B are located on the -Z direction side of the circuit connection pads 12G and 12B, respectively, and are electrically connected to the wiring in the wiring layer 16. The active element 14C is configured in the same manner as the active element 14R. The active element 14C is located on the -Z direction side of the circuit connection pad 12C, and is electrically connected to the cathode common wiring in the wiring layer 16.

Although not illustrated in detail, the wiring in the wiring layer 16 is formed by a conductive material, such as gold, copper, aluminum, or indium tin oxide, is arranged in a matrix (or grid), is appropriately electrically connected to the active elements 14 (14R, 14G, 14B, and 14C) and circuit connection pads 12 (12R, 12G, 12B, and 12C), and is electrically connected to the driver 6.

The substrate surface 10S of the circuit substrate 10 is an extremely smooth flat surface. Specifically, in the circuit substrate 10, the upper surfaces of the insulating layer 11 and circuit connection pads 12R, 12G, 12B, and 12C are extremely smooth flat surfaces parallel to each other, and the distances (i.e., level differences) between these surfaces in the Z direction are extremely small. Thus, the upper surfaces of the insulating layer 11 and circuit connection pads 12R, 12G, 12B, and 12C are located in the same plane.

Specifically, in the circuit substrate 10, a surface roughness (also referred to as roughness or surface maximum step) Rpv of the substrate surface 10S (or the upper surfaces of the insulating layer 11 and circuit connection pads 12R, 12G, 12B, and 12C) is 10 nm or less.

### <1-4. Configuration of thin-film layer group>

As illustrated in FIGs. 4 and 5, in the thin-film layer group 18, the three thin-film layers 20, the first thin-film layer 20R, second thin-film layer 20G, and third thin-film layer 20B, are stacked in the +Z direction. The thin-film layer group 18 is physically bonded onto the circuit substrate 10 by means of intermolecular force, and is electrically connected to the circuit substrate 10.

In the thin-film layer group 18, multiple pixels (or pixel portions 8) are arranged in a matrix in a region of the LED display portion 2. In the thin-film layer group 18, each pixel portion 8 has a length of 1 mm or more in the X and Y directions, and has a thickness of 100 µm or less in the Z direction. A pixel portion 8 is principally constituted by four vertical wirings 22R, 22G, 22B, and 22C (hereinafter also referred to collectively as vertical wirings 22), and one light emitting portion 24. When the pixel portion 8 is viewed in the Z direction, the four vertical wirings 22 are located at four corners, and the light emitting portion 24 is surrounded by the vertical wirings 22 and located in the pixel portion 8. The vertical wirings 22 correspond to anodes and cathodes.

The vertical wiring 22R is constituted by the anode pad 44aR, a dummy pillar 45R, a dummy pad 47G, a dummy pillar 45G2, a dummy pad 47B2, and a dummy pillar 45B4. The vertical wiring 22G is constituted by the anode pad 44aG1, an anode pillar 42aG, an anode pad 44aG2, a dummy pillar 45G1, a dummy pad 47B1, and a dummy pillar 45B3. The vertical wiring 22B is constituted by the anode pad 44aB1, an anode pillar 42aBl, an anode pad 44aB2, an anode pillar 42aB2, an anode pad 44aB3, and a dummy pillar 45B1. The vertical wiring 22C is constituted by the cathode pad 41cR, a cathode pillar 40cR, a cathode pad 41cG, a cathode pillar 40cG, a cathode pad 41cB, and a dummy pillar 45B2.

The light emitting portion 24 is constituted by the thin-film LEDs 30R, 30G, and 30B, which are arranged in the +Z direction and overlap as viewed in the Z direction. The thin-film LEDs 30R, 30G, and 30B are stacked in the Z direction such that their centers coincide and are located at a center of the pixel portion 8 (i.e., a center of the pixel area) and positions of their outlines coincide in the X and Y directions. Hereinafter, the thin-film LEDs 30R, 30G, and 30B may be referred to collectively as thin-film LEDs 30.

The cathode common wiring is disposed in the circuit substrate 10. The cathode common wiring includes wirings linearly arranged in the X and Y directions outside the LED display portion 2, and wirings linearly arranged in the X direction between light emitting portion rows that are each constituted by multiple light emitting portions 24 arranged in the X direction and that are arranged in the Y direction. Also, the cathode common wiring terminates at a common cathode connection terminal of the driver 6.

### <1-4-1. Configuration of first thin-film layer>

As illustrated in FIGs. 4, 5, and 6, the first thin-film layer 20R is constituted by the base layer 26R, serving as a first planarized layer, a cover layer 28R, the thin-film LED 30R, serving as a first semiconductor element, an anode electrode 32R, a cathode electrode 34R, lead-out wirings 36aR and 36cR, interlayer insulating films 38aR and 38cR, the anode pillars 42aG and 42aB1, the anode pads 44aG1, 44aB1, and 44aR, the cathode pillar 40cR, the cathode pad 41cR, and the dummy pillar 45R.

The base layer 26R is formed by, for example, transparent insulating material including or consisting of organic insulating material, such as polyimide resin, epoxy resin, or acrylic resin, or inorganic insulating material, such as SiO₂ or SiN, and has sufficient insulating properties. In the AA cross-section direction Da (see FIG. 4), the base layer 26R extends from one end to the other end of the pixel portion 8. Also, in the BB cross-section direction Db (see FIG. 5), the base layer 26R extends from one end to the other end of the pixel portion 8. Hereinafter, the upper surface of the base layer 26R may also be referred to as a base layer upper surface 26RS1, and a lower surface of the base layer 26R may also be referred to as a base layer lower surface 26RS2.

The thin-film LED 30R is located at a central portion of the pixel portion 8 in each of the AA cross-section direction Da and BB cross-section direction Db, and has a length within a predetermined range in each of the AA cross-section direction Da and BB cross-section direction Db. The thin-film LED 30R has a thickness of 3 µm or less in the Z direction. The thin-film LED 30R is a thin-film inorganic light emitting element embedded in the cover layer 28R. A light emitting surface, which is an upper surface, of the thin-film LED 30R is a flat surface along the X and Y directions. The thin-film LED 30R is an LED that emits red light and that is formed by, for example, III-V compound semiconductor material, such as GaAs-based material. The anode electrode 32R is disposed on an anode formed at a central portion of the +Z direction side of the thin-film LED 30R. The cathode electrode 34R is disposed on a cathode formed on the -X and -Y direction side of the +Z direction side of the thin-film LED 30R.

The lead-out wiring 36aR (see FIG. 5) is in contact with both an upper surface of the anode electrode 32R and the anode pad 44aR, and electrically connects them. The interlayer insulating film 38aR is formed by insulating material, is disposed between the lead-out wiring 36aR and the thin-film LED 30R, and is wider than the lead-out wiring 36aR as viewed in the Z direction. The interlayer insulating film 38aR prevents unwanted short-circuiting between the lead-out wiring 36aR and the thin-film LED 30R.

The lead-out wiring 36cR (see FIG. 4) is in contact with both an upper surface of the cathode electrode 34R and the cathode pad 4lcR, and electrically connects them. The interlayer insulating film 38cR is formed by insulating material similarly to the interlayer insulating film 38aR (see FIG. 5), is disposed between the lead-out wiring 36cR and the thin-film LED 30R, and is wider than the lead-out wiring 36cR as viewed in the Z direction. The interlayer insulating film 38cR prevents unwanted short-circuiting between the lead-out wiring 36cR and the thin-film LED 30R.

The anode pillar 42aG (see FIG. 4) is disposed at a position facing the circuit connection pad 12G of the circuit substrate 10 in the Z direction, and forms part of the vertical wiring 22G. The anode pillar 42aG is formed on (or on the +Z direction side of) and integrally with the anode pad 44aG1. An upper surface of the anode pillar 42aG is exposed from the cover layer 28R. The lower surface of the anode pad 44aG1 is exposed from the base layer 26R.

The anode pillar 42aB1 (see FIG. 5) is disposed at a position facing the circuit connection pad 12B of the circuit substrate 10 in the Z direction, and forms part of the vertical wiring 22B. The anode pillar 42aB1 is formed on (or on the +Z direction side of) and integrally with the anode pad 44aB1. An upper surface of the anode pillar 42aB1 is exposed from the cover layer 28R. The lower surface of the anode pad 44aB1 is exposed from the base layer 26R.

The cathode pillar 40cR (see FIG. 4) is disposed at a position facing the circuit connection pad 12C of the circuit substrate 10 in the Z direction, and forms part of the vertical wiring 22C. The cathode pillar 40cR is formed on (or on the +Z direction side of) and integrally with the cathode pad 41cR. An upper surface of the cathode pillar 40cR is exposed from the cover layer 28R. The lower surface of the cathode pad 41cR is exposed from the base layer 26R.

The dummy pillar 45R (see FIG. 5) is disposed at a position facing the circuit connection pad 12R of the circuit substrate 10 in the Z direction, and forms part of the vertical wiring 22R. The dummy pillar 45R is formed on (or on the +Z direction side of) and integrally with the anode pad 44aR. An upper surface of the dummy pillar 45R is exposed from the cover layer 28R. The lower surface of the anode pad 44aR is exposed from the base layer 26R.

The anode electrode 32R, cathode electrode 34R, lead-out wirings 36aR and 36cR, anode pads 44aG1, 44aBl, and 44aR, and cathode pad 41cR are formed by conductive material, such as gold, copper, aluminum, or indium tin oxide. The anode pillars 42aG and 42aB1, cathode pillar 40cR, and dummy pillar 45R are formed by conductive material, such as gold, copper, or aluminum, having high thermal conductivity. The interlayer insulating films 38aR and 38cR are preferably transparent to wavelengths of light emitted by the thin-film LED 30R.

The cover layer 28R is formed by, for example, the same transparent insulating material as the base layer 26R, has sufficient insulating properties, and is transparent at least to wavelengths of light emitted by the thin-film LED 30R. The cover layer 28R is disposed to cover the base layer 26R, thin-film LED 30R, anode electrode 32R, cathode electrode 34R, lead-out wirings 36aR and 36cR, interlayer insulating films 38aR and 38cR, anode pads 44aG1, 44aB1, and 44aR, and cathode pad 41cR from the +Z direction side, excluding the anode pillars 42aG and 42aB1, cathode pillar 40cR, and dummy pillar 45R. The thin-film LED 30R, anode electrode 32R, cathode electrode 34R, lead-out wirings 36aR and 36cR, interlayer insulating films 38aR and 38cR, anode pads 44aG1, 44aB1, and 44aR, and cathode pad 41cR are embedded in between the cover layer 28R and the base layer 26R.

An upper surface (hereinafter also referred to as a first thin-film layer upper surface 20RS1) of the first thin-film layer 20R is an extremely smooth flat surface. Specifically, in the first thin-film layer 20R, the upper surfaces of the cover layer 28R, anode pillars 42aG and 42aB1, cathode pillar 40cR, and dummy pillar 45R are extremely smooth flat surfaces parallel to each other, and the distances (i.e., level differences) between these surfaces in the Z direction are extremely small. Thus, the upper surfaces of the cover layer 28R, anode pillars 42aG and 42aB1, cathode pillar 40cR, and dummy pillar 45R are located in the same plane.

Specifically, in the first thin-film layer 20R, a surface roughness Rpv of the first thin-film layer upper surface 20RS1 (or the upper surfaces of the cover layer 28R, anode pillars 42aG and 42aB1, cathode pillar 40cR, and dummy pillar 45R) is 10 nm or less.

A lower surface (hereinafter also referred to as a first thin-film layer lower surface 20RS2) of the first thin-film layer 20R is an extremely smooth flat surface, except for an air passage groove (or air vent groove) 50R (to be described in detail later). Specifically, in the first thin-film layer 20R, the lower surfaces of the base layer 26R, anode pads 44aG1, 44aB1, and 44aR, and cathode pad 41cR are extremely smooth flat surfaces parallel to each other, and the distances (i.e., level differences) between these surfaces in the Z direction are extremely small. Thus, the lower surfaces of the base layer 26R, anode pads 44aG1, 44aB1, and 44aR, and cathode pad 41cR are located in the same plane.

Specifically, in the first thin-film layer 20R, a surface roughness Rpv of the first thin-film layer lower surface 20RS2 (or the lower surfaces of the base layer 26R, anode pads 44aG1, 44aB1, and 44aR, and cathode pad 41cR) is 10 nm or less.

### <1-4-2. Configuration of air passage groove>

As illustrated in FIGs. 2, 4, 5, and 6, the air passage groove 50R, serving as a first groove, is formed in the entire region of the base layer lower surface 26RS2. The air passage groove 50R has a semicircular transverse cross-section, and is recessed in the +Z direction. Thus, while the portion of the base layer lower surface 26RS2 (or first thin-film layer lower surface 20RS2) in which the air passage groove 50R is not formed is in contact with the substrate surface 10S, the portion of the base layer lower surface 26RS2 (or first thin-film layer lower surface 20RS2) in which the air passage groove 50R is formed is not in contact with the substrate surface 10S, and forms a gap with the substrate surface 10S. The air passage groove 50R is constituted by multiple groove portions connected to each other over the entire region of the base layer lower surface 26RS2, and has ends in the X and Y directions, which are located at end surfaces of the base layer 26R in the X and Y directions. Thus, the air passage groove 50R communicates with the outside of the base layer 26R through air passage openings (or vents) having semicircular shapes and formed in the end surfaces of the base layer 26R in the X and Y directions, which allows air in the air passage groove 50R to be discharged to the outside of the base layer 26R.

The air passage groove 50R is a combination of linear groove portions extending in the X direction between the pixel portions 8 and linear groove portions extending in the Y direction between the pixel portions 8, and has a grid pattern having squares surrounding the respective pixel portions 8, as viewed in the Z direction. Thus, for each pixel portion 8, the air passage groove 50R is located outside the vertical wirings 22 (or the cathode pad 41cR and anode pads 44aG1, 44aR, and 44aB) in the X and Y directions, as viewed from the center of the pixel portion 8. Thus, the air passage groove 50R is located in a region outside the thin-film LEDs 30R, cathode pads 41cR, and anode pads 44aG1, 44aR, and 44a8 (or in a region that does not overlap the thin-film LEDs 30R, cathode pads 41cR, and anode pads 44aG1, 44aR, and 44aB), as viewed in the Z direction. Hereinafter, the cathode pads 41cR and anode pads 44aG1, 44aR, and 44aB1 may also be referred to as first connections. The air passage groove 50R can be said to extend in directions having components in the X and Y directions in which the multiple thin-film LEDs 30R are arranged.

A height (or depth) of the air passage groove 50R in the Z direction is not more than half a height of the base layer 26R, and is uniform over the entire base layer lower surface 26RS2. As such, in the LED display device 1, the height of the air passage groove 50R is not too large. This ensures the strength of the base layer 26R. In the LED display device 1, to facilitate discharge of air between the base layer 26R and the substrate surface 10S to the outside, it is preferable to make the height of the air passage groove 50R large and make the area of the transverse cross-section as large as possible while ensuring the strength of the base layer 26R.

### <1-4-3. Configuration of second thin-film layer>

As illustrated in FIGs. 4, 5, and 7, the second thin-film layer 20G is constituted by a base layer 26G, serving as a second planarized layer, a cover layer 28G, the thin-film LED 30G, serving as a second semiconductor element, an anode electrode 32G, a cathode electrode 34G, lead-out wirings 36aG and 36cG, interlayer insulating films 38aG and 38cG, the anode pillar 42aB2, the anode pads 44aB2 and 44aG2, the cathode pillar 40cG, the cathode pad 41cG, the dummy pillars 45G1 and 45G2, and the dummy pad 47G.

The base layer 26G is formed by the same material as the base layer 26R, has sufficient insulating properties, and is transparent at least to wavelengths of light emitted by the thin-film LEDs 30R and 30G. In the AA cross-section direction Da (see FIG. 4), the base layer 26G extends from one end to the other end of the pixel portion 8. In the BB cross-section direction Db (see FIG. 5), the base layer 26G extends from one end to the other end of the pixel portion 8. Hereinafter, an upper surface of the base layer 26G may also be referred to as a base layer upper surface 26GS1, and a lower surface of the base layer 26G may also be referred to as a base layer lower surface 26GS2.

The thin-film LED 30G is located at a central portion of the pixel portion 8 in each of the AA cross-section direction Da and BB cross-section direction Db, and has a length within a predetermined range in each of the AA cross-section direction Da and BB cross-section direction Db. The thin-film LED 30G has a thickness of 3 µm or less in the Z direction. The thin-film LED 30G is a thin-film inorganic light emitting element embedded in the cover layer 28G. A light emitting surface, which is an upper surface, of the thin-film LED 30G is a flat surface along the X and Y directions. The thin-film LED 30G is an LED that emits green light and that is formed by, for example, GaN-based material or GaP-based material. The anode electrode 32G is disposed on an anode formed at a central portion of the +Z direction side of the thin-film LED 30G. The cathode electrode 34G is disposed on a cathode formed on the -X and -Y direction side of the +Z direction side of the thin-film LED 30G.

The lead-out wiring 36aG (see FIG. 4) is in contact with both an upper surface of the anode electrode 32G and the anode pad 44aG2, and electrically connects them. The interlayer insulating film 38aG is formed by insulating material, is disposed between the lead-out wiring 36aG and the thin-film LED 30G, and is wider than the lead-out wiring 36aG as viewed in the Z direction. The interlayer insulating film 38aG prevents unwanted short-circuiting between the lead-out wiring 36aG and the thin-film LED 30G.

The lead-out wiring 36cG (see FIG. 4) is in contact with both an upper surface of the cathode electrode 34G and the cathode pad 41cG, and electrically connects them. The interlayer insulating film 38cG is formed by insulating material similarly to the interlayer insulating film 38aG, is disposed between the lead-out wiring 36cG and the thin-film LED 30G, and is wider than the lead-out wiring 36cG as viewed in the Z direction. The interlayer insulating film 38cG prevents unwanted short-circuiting between the lead-out wiring 36cG and the thin-film LED 30G.

The anode pillar 42aB2 (see FIG. 5) is disposed at a position facing the anode pillar 42aB1 of the first thin-film layer 20R in the Z direction, and forms part of the vertical wiring 22B. The anode pillar 42aB2 is formed on (or on the +Z direction side of) and integrally with the anode pad 44aB2. An upper surface of the anode pillar 42aB2 is exposed from the cover layer 28G. A lower surface of the anode pad 44aB2 is exposed from the base layer 26G.

The cathode pillar 40cG (see FIG. 4) is disposed at a position facing the cathode pillar 40cR of the first thin-film layer 20R in the Z direction, and forms part of the vertical wiring 22C. The cathode pillar 40cG is formed on (or on the +Z direction side of) and integrally with the cathode pad 41cG. An upper surface of the cathode pillar 40cG is exposed from the cover layer 28G. A lower surface of the cathode pad 41cG is exposed from the base layer 26G.

The dummy pillar 45G1 (see FIG. 4) is disposed at a position facing the anode pillar 42aG of the first thin-film layer 20R in the Z direction, and forms part of the vertical wiring 22G. The dummy pillar 45G1 is formed on (or on the +Z direction side of) and integrally with the anode pad 44aG2. An upper surface of the dummy pillar 45G1 is exposed from the cover layer 28G. A lower surface of the anode pad 44aG2 is exposed from the base layer 26G.

The dummy pillar 45G2 (see FIG. 5) is disposed at a position facing the dummy pillar 45R of the first thin-film layer 20R in the Z direction, and forms part of the vertical wiring 22R. The dummy pillar 45G2 is formed on (or on the +Z direction side of) and integrally with the dummy pad 47G. An upper surface of the dummy pillar 45G2 is exposed from the cover layer 28G. A lower surface of the dummy pad 47G is exposed from the base layer 26G.

The anode electrode 32G, cathode electrode 34G, lead-out wirings 36aG and 36cG, anode pads 44aB2 and 44aG2, cathode pad 41cG, and dummy pad 47G are formed by conductive material, such as gold, copper, aluminum, or indium tin oxide. The anode pillar 42aB2, cathode pillar 40cG, and dummy pillars 45G1 and 45G2 are formed by conductive material, such as gold, copper, or aluminum, having high thermal conductivity. The interlayer insulating films 38aG and 38cG are preferably transparent to wavelengths of light emitted by the thin-film LEDs 30R and 30G.

The cover layer 28G is formed by, for example, the same transparent insulating material as the base layer 26G, has sufficient insulating properties, and is transparent at least to wavelengths of light emitted by the thin-film LEDs 30R and 30G. The cover layer 28G is disposed to cover the base layer 26G, thin-film LED 30G, anode electrode 32G, cathode electrode 34G, lead-out wirings 36aG and 36cG, interlayer insulating films 38aG and 38cG, anode pad 44aB2, cathode pad 41cG, anode pad 44aG2, and dummy pad 47G from the +Z direction side, excluding the anode pillar 42aB2, cathode pillar 40cG, and dummy pillars 45G1 and 45G2. The thin-film LED 30G, anode electrode 32G, cathode electrode 34G, lead-out wirings 36aG and 36cG, interlayer insulating films 38aG and 38cG, anode pad 44aB2, cathode pad 41cG, anode pad 44aG2, and dummy pad 47G are embedded in between the cover layer 28G and the base layer 26G.

An upper surface (hereinafter also referred to as a second thin-film layer upper surface 20GS1) of the second thin-film layer 20G is an extremely smooth flat surface. Specifically, in the second thin-film layer 20G, the upper surfaces of the cover layer 28G, anode pillar 42aB2, cathode pillar 40cG, and dummy pillars 45G1 and 45G2 are extremely smooth flat surfaces parallel to each other, and the distances (i.e., level differences) between these surfaces in the Z direction are extremely small. Thus, the upper surfaces of the cover layer 28G, anode pillar 42aB2, cathode pillar 40cG, and dummy pillars 45G1 and 45G2 are located in the same plane.

Specifically, in the second thin-film layer 20G, a surface roughness Gpv of the second thin-film layer upper surface 20GS1 (or the upper surfaces of the cover layer 28G, anode pillar 42aB2, cathode pillar 40cG, and dummy pillars 45G1 and 45G2) is 10 nm or less.

A lower surface (hereinafter also referred to as a second thin-film layer lower surface 20GS2) of the second thin-film layer 20G is an extremely smooth flat surface, except for an air passage groove (or air vent groove) 50G. Specifically, in the second thin-film layer 20G, the lower surfaces of the base layer 26G, anode pad 44aB2, cathode pad 41cG, anode pad 44aG2, and dummy pad 47G are extremely smooth flat surfaces parallel to each other, and the distances (i.e., level differences) between these surfaces in the Z direction are extremely small. Thus, the lower surfaces of the base layer 26G, anode pad 44aB2, cathode pad 41cG, anode pad 44aG2, and dummy pad 47G are located in the same plane.

Specifically, in the second thin-film layer 20G, a surface roughness Gpv of the second thin-film layer lower surface 20GS2 (or the lower surfaces of the base layer 26G, anode pad 44aB2, cathode pad 41cG, anode pad 44aG2, and dummy pad 47G) is 10 nm or less.

### <1-4-4. Configuration of air passage groove>

As illustrated in FIGs. 2, 4, 5, and 7, the air passage groove 50G, serving as a second groove, is formed in the base layer lower surface 26GS2 in the same manner as the air passage groove 50R of the base layer 26R. Specifically, the air passage groove 50G has the same shape as and coincides with the air passage groove 50R as viewed in the Z direction, and has the same height (or depth) in the Z direction as the air passage groove 50R. Hereinafter, the anode pads 44aB2 and 44aG2, cathode pad 41cG, and dummy pad 47G may also be referred to as second connections.

### <1-4-5. Configuration of third thin-film layer>

As illustrated in FIGs. 4, 5, and 8, the third thin-film layer 20B is constituted by a base layer 26B, serving as a third planarized layer, a cover layer 28B, the thin-film LED 30B, serving as a third semiconductor element, an anode electrode 32B, a cathode electrode 34B, lead-out wirings 36aB and 36cB, interlayer insulating films 38aB and 38cB, the anode pad 44aB3, the cathode pad 41cB, the dummy pillars 45B1, 45B2, 4583, and 45B4, and the dummy pads 47B1 and 47B2.

The base layer 26B is formed by the same material as the base layer 26R, has sufficient insulating properties, and is transparent at least to wavelengths of light emitted by the thin-film LEDs 30R, 30G and 30B. In the AA cross-section direction Da (see FIG. 4), the base layer 26B extends from one end to the other end of the pixel portion 8. In the BB cross-section direction Db (see FIG. 5), the base layer 26B extends from one end to the other end of the pixel portion 8. Hereinafter, an upper surface of the base layer 26B may also be referred to as a base layer upper surface 26BS1, and a lower surface of the base layer 26B may also be referred to as a base layer lower surface 26BS2.

The thin-film LED 30B is located at a central portion of the pixel portion 8 in each of the AA cross-section direction Da and BB cross-section direction Db, and has a length within a predetermined range in each of the AA cross-section direction Da and BB cross-section direction Db. The thin-film LED 30B has a thickness of 3 µm or less in the Z direction. The thin-film LED 30B is a thin-film inorganic light emitting element embedded in the cover layer 28B. A light emitting surface, which is an upper surface, of the thin-film LED 30B is a flat surface along the X and Y directions. The thin-film LED 30B is an LED that emits blue light and that is formed by, for example, GaN-based material. The anode electrode 32B is disposed on an anode formed at a central portion of the +Z direction side of the thin-film LED 30B. The cathode electrode 34B is disposed on a cathode formed on the -X and -Y direction side of the +Z direction side of the thin-film LED 30B.

The lead-out wiring 36aB (see FIG. 5) is in contact with both an upper surface of the anode electrode 32B and the anode pad 44aB3, and electrically connects them. The interlayer insulating film 38aB is formed by insulating material, is disposed between the lead-out wiring 36aB and the thin-film LED 30B, and is wider than the lead-out wiring 36aB as viewed in the Z direction. The interlayer insulating film 38aB prevents unwanted short-circuiting between the lead-out wiring 36aB and the thin-film LED 30B.

The lead-out wiring 36cB (see FIG. 4) is in contact with both an upper surface of the cathode electrode 34B and the cathode pad 41c8, and electrically connects them. The interlayer insulating film 38cB is formed by insulating material similarly to the interlayer insulating film 38aR, is disposed between the lead-out wiring 36cB and the thin-film LED 30B, and is wider than the lead-out wiring 36cB as viewed in the Z direction. The interlayer insulating film 38cB prevents unwanted short-circuiting between the lead-out wiring 36cB and the thin-film LED 30B.

The dummy pillar 45B1 (see FIG. 5) is disposed at a position facing the anode pillar 42aB2 of the second thin-film layer 20G in the Z direction, and forms part of the vertical wiring 22B. The dummy pillar 45B1 is formed on (or on the +Z direction side of) and integrally with the anode pad 44aB3. An upper surface of the dummy pillar 45B1 is exposed from the cover layer 28B. A lower surface of the anode pad 44aB3 is exposed from the base layer 26B.

The dummy pillar 45B2 (see FIG. 4) is disposed at a position facing the cathode pillar 40cG of the second thin-film layer 20G in the Z direction, and forms part of the vertical wiring 22C. The dummy pillar 45B2 is formed on (or on the +Z direction side of) and integrally with the cathode pad 41cB. An upper surface of the dummy pillar 45B2 is exposed from the cover layer 28B. A lower surface of the cathode pad 41cB is exposed from the base layer 26B.

The dummy pillar 45B3 (see FIG. 4) is disposed at a position facing the dummy pillar 45G1 of the second thin-film layer 20G in the Z direction, and forms part of the vertical wiring 22G. The dummy pillar 45B3 is formed on (or on the +Z direction side of) and integrally with the dummy pad 47B1.

An upper surface of the dummy pillar 45B3 is exposed from the cover layer 28B. A lower surface of the dummy pad 47B1 is exposed from the base layer 26B.

The dummy pillar 45B4 (see FIG. 5) is disposed at a position facing the dummy pillar 45G2 of the second thin-film layer 20G in the Z direction, and forms part of the vertical wiring 22R. The dummy pillar 45B4 is formed on (or on the +Z direction side of) and integrally with the dummy pad 47B2. An upper surface of the dummy pillar 45B4 is exposed from the cover layer 28B. A lower surface of the dummy pad 47B2 is exposed from the base layer 26B.

The anode electrode 32B, cathode electrode 34B, lead-out wirings 36aB and 36cB, anode pad 44aB3, cathode pad 41cB, and dummy pads 47B1 and 47B2 are formed by conductive material, such as gold, copper, aluminum, or indium tin oxide. The dummy pillars 45B1, 45B2, 45B3, and 45B4 are formed by conductive material, such as gold, copper, or aluminum, having high thermal conductivity. The interlayer insulating films 38aB and 38cB are preferably transparent to wavelengths of light emitted by the thin-film LEDs 30R, 30G, and 30B.

The cover layer 28B is formed by, for example, the same transparent insulating material as the base layer 26B, has sufficient insulating properties, and is transparent at least to wavelengths of light emitted by the thin-film LEDs 30R, 30G, and 30B. The cover layer 28B is disposed to cover the base layer 26B, thin-film LED 30B, anode electrode 32B, cathode electrode 34B, lead-out wirings 36aB and 36cB, interlayer insulating films 38aB and 38cB, anode pad 44aB3, cathode pad 41cB, and dummy pads 47B1 and 47B2 from the +Z direction side, excluding the dummy pillars 45B1, 45G2, 45G3, and 45G4. The thin-film LED 30B, anode electrode 32B, cathode electrode 34B, lead-out wirings 36aB and 36cB, interlayer insulating films 38aB and 38cB, anode pad 44aB3, cathode pad 41cB, and dummy pads 47B1 and 47B2 are embedded in between the cover layer 28B and the base layer 26B.

A lower surface (hereinafter also referred to as a third thin-film layer lower surface 20BS2) of the third thin-film layer 20B is an extremely smooth flat surface, except for an air passage groove (or air vent groove) 508. Specifically, in the third thin-film layer 20B, the lower surfaces of the base layer 26B, anode pad 44aB3, cathode pad 41cB, and dummy pads 4781 and 47B2 are extremely smooth flat surfaces parallel to each other, and the distances (i.e., level differences) between these surfaces in the Z direction are extremely small. Thus, the lower surfaces of the base layer 26B, anode pad 44aB3, cathode pad 41cB, and dummy pads 47B1 and 47B2 are located in the same plane.

Specifically, in the third thin-film layer 20B, a surface roughness Gpv of the third thin-film layer lower surface 20BS2 (or the lower surfaces of the base layer 26B, anode pad 44aB3, cathode pad 41cB, and dummy pads 47B1 and 47B2) is 10 nm or less. Hereinafter, the lead-out wirings 36aR, 36cR, 36aG, 36cG, 36aB, and 36cB may also be referred to collectively as lead-out wirings 36.

### <1-4-6. Configuration of air passage groove>

As illustrated in FIGs. 2, 4, 5, and 8, the air passage groove 50B, serving as a third groove, is formed in the base layer lower surface 26BS2 in the same manner as the air passage groove 50R of the base layer 26R and the air passage groove 50G of the base layer 26G. Specifically, the air passage groove 50B has the same shape as and coincides with the air passage grooves 50R and 50G as viewed in the Z direction, and has the same height (or depth) in the Z direction as the air passage grooves 50R and 50G. Hereinafter, the air passage grooves 50R, 50G, and 50B may also be referred to collectively as air passage grooves 50. Also, the anode pad 44aB3, cathode pad 41cB, and dummy pads 47B1 and 47B2 may also be referred to as third connections.

### <1-5. Connection relationship between thin-film layers and circuit substrate>

### <1-5-1. Physical connection relationship between circuit substrate and thin-film layers>

The substrate surface 10S of the circuit substrate 10 and the first thin-film layer lower surface 20RS2 of the first thin-film layer 20R are physically bonded together by intermolecular force except for the air passage groove 50R. The first thin-film layer upper surface 20RS1 of the first thin-film layer 20R and the second thin-film layer lower surface 20GS2 of the second thin-film layer 20G are physically bonded together by intermolecular force except for the air passage groove 50G. The second thin-film layer upper surface 20GS1 of the second thin-film layer 20G and the third thin-film layer lower surface 20BS2 of the third thin-film layer 20B are physically bonded together by intermolecular force except for the air passage groove 50B.

In this manner, in the LED display portion 2, the substrate surface 10S and the first thin-film layer lower surface 20RS2, the first thin-film layer upper surface 20RS1 and the second thin-film layer lower surface 20GS2, and the second thin-film layer upper surface 20GS1 and the third thin-film layer lower surface 20BS2 are each bonded together by intermolecular force, not by metal bonding. Hereinafter, the first thin-film layer lower surface 20RS2, second thin-film layer lower surface 20GS2, and third thin-film layer lower surface 20BS2 may also be referred to collectively as thin-film layer lower surfaces 20S2.

### <1-5-2. Electrical connection relationship between circuit substrate and thin-film layers>

The upper surface of the circuit connection pad 12R (see FIG. 5) is physically bonded to the lower surface of the anode pad 44aR of the first thin-film layer 20R by intermolecular force, and the circuit connection pad 12R is electrically connected to the anode electrode 32R of the thin-film LED 30R through the anode pad 44aR and lead-out wiring 36aR. The upper surface of the dummy pillar 45R is physically bonded to the lower surface of the dummy pad 47G of the second thin-film layer 20G by intermolecular force. The upper surface of the dummy pillar 45G2 is physically bonded to the lower surface of the dummy pad 47B2 of the third thin-film layer 20B by intermolecular force.

The upper surface of the circuit connection pad 12G (see FIG. 4) is physically bonded to the lower surface of the anode pad 44aG1 of the first thin-film layer 20R by intermolecular force. The upper surface of the anode pillar 42aG is physically bonded to the lower surface of the anode pad 44aG2 of the second thin-film layer 20G by intermolecular force. The anode pad 44aG2 is physically in contact with the lead-out wiring 36aG. Thus, the circuit connection pad 12G is electrically connected to the anode electrode 32G of the thin-film LED 30G through the anode pad 44aG1, anode pillar 42aG, anode pad 44aG2, and lead-out wiring 36aG. The upper surface of the dummy pillar 45G1 is physically bonded to the lower surface of the dummy pad 47B1 of the third thin-film layer 20B by intermolecular force.

The upper surface of the circuit connection pad 12B (see FIG. 5) is physically bonded to the lower surface of the anode pad 44aB1 of the first thin-film layer 20R by intermolecular force. The upper surface of the anode pillar 42aB1 is physically bonded to the lower surface of the anode pad 44aB2 of the second thin-film layer 20G by intermolecular force. The upper surface of the anode pillar 42aB2 is physically bonded to the lower surface of the anode pad 44aB3 of the third thin-film layer 20B by intermolecular force. The anode pad 44aB3 is physically in contact with the lead-out wiring 36aB. Thus, the circuit connection pad 12B is electrically connected to the anode electrode 32B of the thin-film LED 30B through the anode pad 44aB1, anode pillar 42aB1, anode pad 44aB2, anode pillar 42aB2, anode pad 44aB3, and lead-out wiring 36aB.

The upper surface of the circuit connection pad 12C (see FIG. 4) is physically bonded to the lower surface of the cathode pad 41cR of the first thin-film layer 20R by intermolecular force. The upper surface of the cathode pillar 40cR is physically bonded to the lower surface of the cathode pad 41cG of the second thin-film layer 20G by intermolecular force. The upper surface of the cathode pillar 40cG is physically bonded to the lower surface of the cathode pad 41cB of the third thin-film layer 20B by intermolecular force. The cathode pad 41cB is physically in contact with the lead-out wiring 36cB. Thus, the cathode electrode 34B is electrically connected to the cathode common wiring of the wiring layer 16 through the lead-out wiring 36cB, cathode pad 41cB, cathode pillar 40cG, cathode pad 41cG, cathode pillar 40cR, cathode pad 41cR, and circuit connection pad 12C.

The lead-out wiring 36cG is physically in contact with the cathode pad 41cG. Thus, the cathode electrode 34G is electrically connected to the cathode common wiring of the wiring layer 16 through the lead-out wiring 36cG, cathode pad 41cG, cathode pillar 40cR, cathode pad 41cR, and circuit connection pad 12C.

The lead-out wiring 36cR is physically in contact with the cathode pad 41cR. Thus, the cathode electrode 34R is electrically connected to the cathode common wiring of the wiring layer 16 through the lead-out wiring 36cR, cathode pad 41cR, and circuit connection pad 12C.

### <1-6. Method of manufacturing LED display portion>

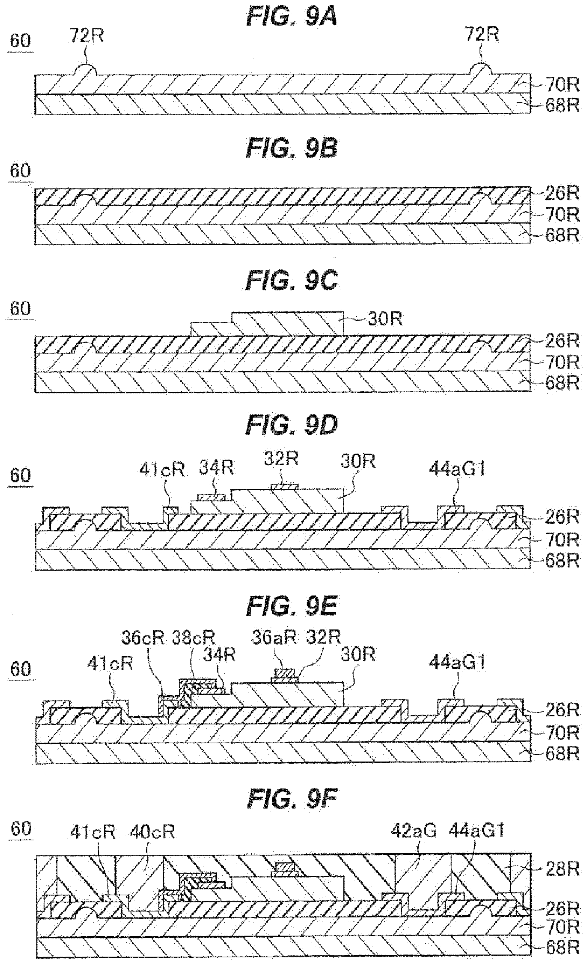

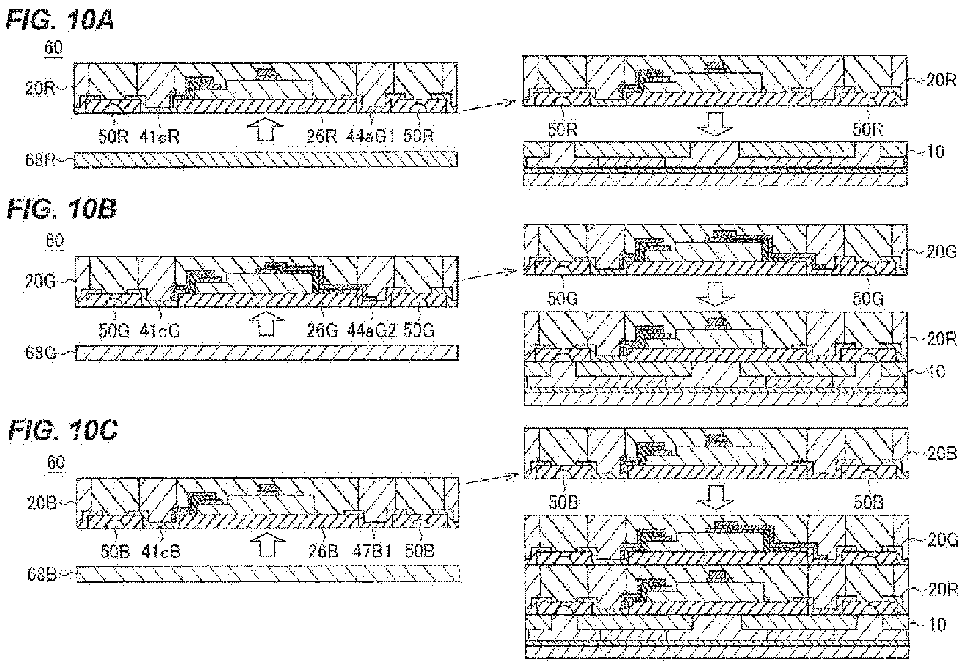

The following describes an example of a method of manufacturing the LED display portion 2 of the LED display device 1 with reference to FIGs. 9A to 9F and 10A to 10C, focusing on one pixel portion 8. FIGs. 9A to 9F and 10A to 10C are each a schematic cross-sectional view with the +Z direction directed upward. For convenience of explanation, the +Z direction may also be referred to as an upward direction, and the -Z direction may also be referred to as a downward direction.

### <1-6-1. Method of manufacturing first thin-film layer>

A method of manufacturing the first thin-film layer 20R will be first described with reference to FIGs. 9A to 9F. First, in a sacrificial layer forming step, as illustrated in FIG. 9A, a manufacturing apparatus 60 forms a sacrificial layer 70R on the upper side, i.e., +Z direction side, of a predetermined formation substrate 68R. The sacrificial layer 70R is formed by, for example, SiO₂, aluminum, or alumina, and can be removed by etching. A projection 72R corresponding to the air passage groove 50R is formed in a grid pattern in the sacrificial layer 70R. A surface of the sacrificial layer 70R is planarized to have a surface roughness Rpv of 10 nm or less, except for the grid pattern projection 72R. The sacrificial layer 70R may have a structure obtained by combining different materials that can be removed by the same chemical liquid. For example, when the grid pattern projection 72R is formed by aluminum on a flat alumina layer, the manufacturing apparatus 60 can simultaneously remove the alumina layer and aluminum projection with phosphoric acid.

Then, in a planarized layer forming step, as illustrated in FIG. 9B, the manufacturing apparatus 60 forms the base layer 26R on the upper side of the sacrificial layer 70R. In a semiconductor element forming step, as illustrated in FIG. 9C, the manufacturing apparatus 60 bonds and forms the thin-film LED 30R on the upper side of the base layer 26R. Then, in a connection forming step, as illustrated in FIG. 9D, the manufacturing apparatus 60 forms openings in the base layer 26R by patterning the base layer 26R by etching, and forms the anode electrode 32R, cathode electrode 34R, anode pads 44aG1, 44aR (see FIG. 5), and 44aB1 (see FIG. 5), and cathode pad 41cR on the thin-film LED 30R and base layer 26R, by performing patterning using a method such as lithography or sputtering.

Then, in a lead-out wiring forming step, as illustrated in FIG. 9E, the manufacturing apparatus 60 forms, on the thin-film LED 30R and base layer 26R, the interlayer insulating films 38cR and 38aR (see FIG. 5) and lead-out wirings 36cR and 36aR (see FIG. 5) to connect the cathode electrode 34R and the cathode pad 41cR and connect the anode electrode 32R (see FIG. 5) and the anode pad 44aR (see FIG. 5), by performing patterning using a method such as lithography or sputtering.

Then, in a conductive pillar forming step, as illustrated in FIG. 9F, the manufacturing apparatus 60 forms the cover layer 28R on the thin-film LED 30R, base layer 26R, anode electrode 32R, cathode electrode 34R, anode pads 44aG1, 44aR, and 44a81, cathode pad 41cR, interlayer insulating films 38cR and 38aR, and lead-out wirings 36cR and 36aR to embed them therein, forms openings in the cover layer 28R by patterning the cover layer 28R, and then forms the anode pillar 42aG, cathode pillar 40cR, dummy pillar 45R (see FIG. 5), and anode pillar 42aB1 (see FIG. 5) on the anode pad 44aG1, cathode pad 41cR, anode pad 44aR (see FIG. 5), and anode pad 44aB1 (see FIG. 5), which are exposed through the openings, by plating. Then, the manufacturing apparatus 60 planarizes the upper surfaces of the cover layer 28R, anode pillar 42aG, cathode pillar 40cR, dummy pillar 45R (see FIG. 5), and anode pillar 42aB1 (see FIG. 5) by chemical mechanical polishing (CMP). Thereby, the upper surfaces of the anode pillar 42aG, cathode pillar 40cR, dummy pillar 45R (see FIG. 5), and anode pillar 42aB1 (see FIG. 5) are exposed from the cover layer 28R. The connection forming step may include the lead-out wiring forming step (see FIG. 9E) and conductive pillar forming step (see FIG. 9F).

Methods of manufacturing the second thin-film layer 20G and third thin-film layer 20B are substantially the same as the above-described method of manufacturing the first thin-film layer 20R, and thus description thereof will be omitted.

### <1-6-2. Process of stacking and bonding>

Next, a process of stacking and bonding the first thin-film layer 20R, second thin-film layer 20G, and third thin-film layer 20B manufactured by the above manufacturing methods onto the circuit substrate 10 will be described with reference to FIGs. 10A to 10C.

First, in a groove forming step, as illustrated in the left side of FIG. 10A, the manufacturing apparatus 60 separates the first thin-film layer 20R from the formation substrate 68R by etching and removing the sacrificial layer 70R (see FIG. 9F). Thereby, the lower surfaces of the anode pad 44aG1, cathode pad 41cR, anode pad 44aR (see FIG. 5), and anode pad 44aBl (see FIG. 5) are exposed from the base layer 26R. At this time, the air passage groove 50R, which is a recess having a grid pattern, is formed in the lower surface of the base layer 26R. Except for the air passage groove 50R, the lower surfaces of the base layer 26R, anode pad 44aG1, cathode pad 41cR, anode pad 44aR (see FIG. 5), and anode pad 44aB1 (see FIG. 5) are smooth and have a surface roughness Rpv of 10 nm or less, following the upper surface of the sacrificial layer 70R (see FIG. 9F).

Then, as illustrated in the right side of FIG. 10A, the manufacturing apparatus 60 bonds the separated first thin-film layer 20R to the upper surface of the circuit substrate 10 by means of intermolecular force by using a known bonding method. At this time, the manufacturing apparatus 60 discharges air between the circuit substrate 10 and the first thin-film layer 20R to the outside through the air passage groove 50R from the end surfaces of the first thin-film layer 20R in the X and Y directions, thereby preventing air bubbles from occurring between the circuit substrate 10 and the first thin-film layer 20R due to the first thin-film layer 20R slightly waving.

Then, as illustrated in the left side of FIG. 10B, the manufacturing apparatus 60 separates the second thin-film layer 20G from the formation substrate 68G by etching and removing the sacrificial layer (not illustrated). Thereby, the lower surfaces of the anode pad 44aG2, cathode pad 41cG, anode pad 44aB2 (see FIG. 5), and dummy pad 47G (see FIG. 5) are exposed from the base layer 26G. At this time, the air passage groove 50G, which is a recess having a grid pattern, is formed in the lower surface of the base layer 26G. Except for the air passage groove 50G, the lower surfaces of the base layer 26G, anode pad 44aG2, cathode pad 41cG, anode pad 44aB2 (see FIG. 5), and dummy pad 47G (see FIG. 5) are smooth and have a surface roughness Rpv of 10 nm or less, following the upper surface of the sacrificial layer (not illustrated).

Then, as illustrated in the right side of FIG. 10B, the manufacturing apparatus 60 bonds the separated second thin-film layer 20G to the upper surface of the first thin-film layer 20R bonded to the circuit substrate 10 in FIG. 10A, by means of intermolecular force by using a known bonding method. At this time, the manufacturing apparatus 60 discharges air between the first thin-film layer 20R and the second thin-film layer 20G to the outside through the air passage groove 50G from the end surfaces of the second thin-film layer 20G in the X and Y directions, thereby preventing air bubbles from occurring between the first thin-film layer 20R and the second thin-film layer 20G due to the second thin-film layer 20G slightly waving.

Then, as illustrated in the left side of FIG. 10C, the manufacturing apparatus 60 separates the third thin-film layer 20B from the formation substrate 68B by etching and removing the sacrificial layer (not illustrated). Thereby, the lower surfaces of the dummy pad 47B1, cathode pad 41cB, anode pad 44aB3 (see FIG. 5), and dummy pad 47B2 (see FIG. 5) are exposed from the base layer 26B. At this time, the air passage groove 50B, which is a recess having a grid pattern, is formed in the lower surface of the base layer 26B. Except for the air passage groove 50B, the lower surfaces of the base layer 26B, dummy pad 47B1, cathode pad 41cB, anode pad 44aB3 (see FIG. 5), and dummy pad 47B2 are smooth and have a surface roughness Rpv of 10 nm or less, following the upper surface of the sacrificial layer (not illustrated).

Then, as illustrated in the right side of FIG. 10C, the manufacturing apparatus 60 bonds the separated third thin-film layer 20B to the upper surface of the second thin-film layer 20G bonded to the first thin-film layer 20R in FIG. 10B, by means of intermolecular force by using a known bonding method. At this time, the manufacturing apparatus 60 discharges air between the second thin-film layer 20G and the third thin-film layer 20B to the outside through the air passage groove 50B from the end surfaces of the third thin-film layer 20B in the X and Y directions, thereby preventing air bubbles from occurring between the second thin-film layer 20G and the third thin-film layer 20B due to the third thin-film layer 20B slightly waving.

### <1-7. Operation>

In the LED display device 1 with the above configuration, when the LED display portion 2 is driven, power, a clock signal, image data, and the like are input to the driver 6 through the connection terminal portion 5 from an external circuit (not illustrated). Then, in the LED display device 1, signals for turning on/off the active elements 14R, 14G, and 14B and drive currents are selectively supplied from the driver 6 to the wiring layer 16 of the circuit substrate 10. The supplied drive currents are supplied to the thin-film LEDs 30R, 30G, and 30B through the circuit connection pads 12, the vertical wirings 22R, 22G, and 22B, the lead-out wirings 36 in the thin-film layers 20 (i.e., first thin-film layer 20R, second thin-film layer 20G, and third thin-film layer 20B), in accordance with turning on/off of the active elements 14R, 14G, and 14B. Thereby, the LED display portion 2 emits light.

### <1-8. Advantages>

In the LED display device 1 having the above configuration, the air passage grooves 50 are provided in the thin-film layer lower surfaces 20S2 of the respective thin-film layers 20. Thus, in the LED display device 1, for each thin-film layer 20, when the thin-film layer 20 (referred to below as a bonding object) is bonded to the circuit substrate 10 or another thin-film layer 20 (referred to below as a bonded object) located on the -Z direction side of the thin-film layer 20 by means of intermolecular force, it is possible to disperse and discharge air through the air passage groove 50 to the outside, preventing a mass of air from locally remaining between the bonding object and the bonded object. Thus, even when the bonding object is wavy, it is possible to prevent air bubbles from occurring between the bonding object and the bonded object during the bonding. In this manner, in the manufacture of the LED display device 1, for each thin-film layer 20, when the thin-film layer 20, which is film-shaped and thin, is moved in the Z direction and bonded to the bonded object, the thin-film layer 20 can be accurately bonded to the bonded object.

Also, in the LED display device 1, the air passage grooves 50 are provided in the thin-film layer lower surfaces 20S2 of the respective thin-film layers 20. Thereby, in the manufacture, for each thin-film layer 20, when the thin-film layer 20 is bonded to the bonded object, it is possible to prevent air bubbles from occurring between the thin-film layer 20 and the bonded object by only application of existing methods without requiring a dedicated special device or material.

Here, it is conceivable to form the air passage groove 50R by cutting the lower surface of the base layer 26R. However, in this case, it is difficult to maintain the surface roughness Rpv of the first thin-film layer lower surface 20RS2, and it is also difficult to accurately adjust the height of the air passage groove 50 in the Z direction.

On the other hand, in the LED display device 1, in the manufacture, the projection 72R is formed in a grid pattern in the upper surface of the sacrificial layer 70R planarized to have a surface roughness Rpv of 10 nm or less except for the projection 72R, and the first thin-film layer 20R is separated from the formation substrate 68R by etching and removing the sacrificial layer 70R (see FIG. 9F). Thus, in the LED display device 1, the first thin-film layer lower surface 20RS2 can be planarized to have a surface roughness Rpv of 10 nm or less except for the air passage groove 50R, following the upper surface of the sacrificial layer 70R (see FIG. 9F). In addition, the height of the air passage groove 50R from the first thin-film layer lower surface 20RS2 in the Z direction can be accurately adjusted to about 20 to 50 µm. The same applies to the second thin-film layer 20G and third thin-film layer 20B.

Moreover, in the LED display device 1, in the manufacture, there is no need to bond a bonding object to the bonded object while bending the bonding object so that the bonding object is brought into contact with the bonded object gradually from one end toward the other end in one of the X and Y directions, in order to bond them together while removing air between the bonding object and the bonded object. Thus, in the LED display device 1, it is possible to move the bonding object in the Z direction to bond the bonding object to the bonded object while keeping the bonding object flat. Thus, in the LED display device 1, it is possible to mount the bonding object on the bonded object with a high accuracy of about 1 µm in the X and Y directions. Also, in the LED display device 1, it is possible to eliminate the need for a device or process for deforming the bonding object, and simplify the mounting process.

If the air passage groove 50R is disposed to overlap the thin-film LEDs 30R as viewed in the Z direction, light emitted from the thin-film LEDs 30R may be scattered by the air passage groove 50R when passing through the air passage groove 50R, and the dissipation of heat generated by the thin-film LEDs 30R may be reduced, which may reduce the luminous efficiency.

On the other hand, in the LED display device 1, the air passage groove 50R is disposed to surround the thin-film LEDs 30R, or disposed such that it does not overlap the thin-film LEDs 30R, as viewed in the Z direction. Thus, in the LED display device 1, it is possible to prevent light emitted from the thin-film LEDs 30R from being scattered by the air passage groove 50R when passing through the air passage groove 50R, and maintain the dissipation of heat generated by the thin-film LEDs 30R, thereby maintaining the optical properties. The same applies to the second thin-film layer 20G and third thin-film layer 20B.

Also, if the air passage groove 50R is disposed to overlap the vertical wirings 22 as viewed in the Z direction, the air passage groove 50R may interfere with the electrical connection between the thin-film LEDs 30R and the circuit substrate 10.

On the other hand, in the LED display device 1, the air passage groove 50R is disposed in an area around the thin-film LEDs 30R and vertical wirings 22 to surround the thin-film LEDs 30R and vertical wirings 22, or disposed such that it does not overlap the thin-film LEDs 30R and vertical wirings 22, as viewed in the Z direction. Thus, in the LED display device 1, it is possible to prevent the air passage groove 50R from interfering with the electrical connection between the thin-film LEDs 30R and the circuit substrate 10. The same applies to the second thin-film layer 20G and third thin-film layer 20B. Also, in the LED display device 1, the thin-film layers 20 include the vertical wirings 22 in which the anode pillars, cathode pillars, and dummy pillars, serving as electrode pillars, are disposed on the anode pads, cathode pads, and dummy pads. Thus, in the LED display device 1, heat generated by the thin-film LEDs 30 can be dissipated to the outside of the thin-film layers 20 through the vertical wirings 22, which can improve the heat dissipation.

To facilitate removal of air between the first thin-film layer lower surface 20RS2 and the substrate surface 10S when the first thin-film layer 20R is bonded to the circuit substrate 10, it is conceivable to form an air passage groove recessed in the -Z direction in the substrate surface 10S, not in the lower surface of the base layer 26R. However, processing the substrate surface 10S of the circuit substrate 10 to form a recess therein is more difficult than forming the air passage groove 50R in the base layer 26R of the first thin-film layer 20R.

On the other hand, in the LED display device 1, in the manufacture, the air passage groove 50R can be easily formed in the lower surface of the base layer 26R by only removing the projection 72R by etching.

Moreover, in the LED display device 1, the air passage grooves 50R, 50G, and 50B have the same shape and coincide with each other, as viewed in the Z direction. This makes it easy to make the thin-film layers 20 have structural symmetry and equalize the optical properties of the thin-film layers 20. Also, in the LED display device 1, in the process of stacking and bonding the first thin-film layer 20R, second thin-film layer 20G, and third thin-film layer 20B, it is possible to easily check that all the air passage grooves 50R, 50G, and 50B are aligned without displacement in the X and Y directions.

As above, the LED display device 1 includes the base layer 26R having insulating properties; the multiple thin-film LEDs 30R formed on the base layer upper surface 26RS1, serving as a first surface; the cathode pads 41cR, and anode pads 44aG1, 44aR, and 44aB1 connected to the thin-film LEDs 30R; and the air passage groove 50R provided in the base layer lower surface 26RS2, serving as a second surface, that is a surface opposite the base layer upper surface 26RS1.

The air passage groove 50R is formed in a region outside the thin-film LEDs 30R (or in a region that does not overlap the thin-film LEDs 30R) as viewed in the light emitting direction De, serving as a first direction, perpendicular to the upper surface of the base layer 26R.

Thereby, in the LED display device 1, it is possible to improve the positional accuracy of the first thin-film layer 20R with respect to the circuit substrate 10 while maintaining the optical properties, by preventing a mass of air from locally remaining between the base layer 26R and the circuit substrate 10 by dispersing air when the base layer 26R is bonded to the circuit substrate 10, which is the bonded object.

The present embodiment provides a semiconductor device including a planarized layer having insulating properties, the planarized layer having a first surface and a second surface opposite the first surface; multiple semiconductor elements formed on the first surface of the planarized layer; multiple connections connected to the multiple semiconductor elements; and a groove provided in the second surface of the planarized layer. The groove is formed in a region outside the multiple semiconductor elements as viewed in a direction perpendicular to the first surface. With this configuration, it is possible to improve the positional accuracy of the semiconductor device with respect to a bonded object, by preventing a mass of air from locally remaining between the semiconductor device and the bonded object by dispersing air when the semiconductor device is bonded to the bonded object.

The present embodiment can provide a semiconductor device and a method of manufacturing the same capable of improving positional accuracy.

### <2. Second embodiment>

### <2-1. Configuration of LED display device>

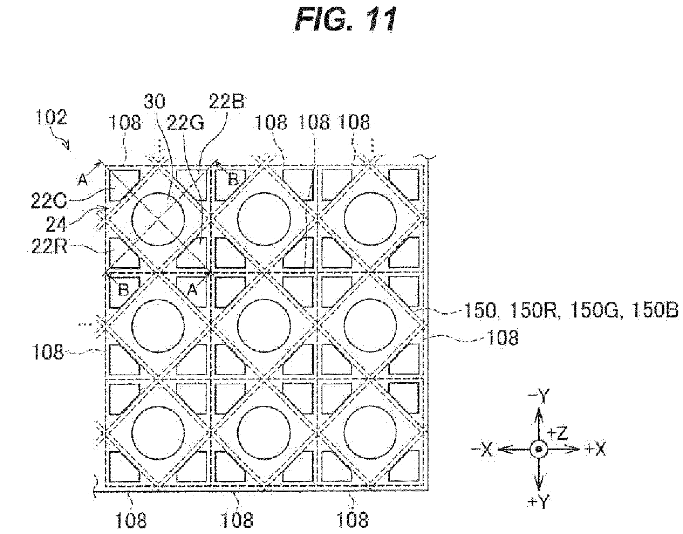

As illustrated in FIG. 1 and FIG. 11, in which elements corresponding to those in FIG. 2 are given the same reference characters, an LED display device 101 according to a second embodiment is different from the LED display device 1 in having an LED display portion 102 instead of the LED display portion 2, but otherwise formed in the same manner.

### <2-2. Entire configuration of LED display portion>

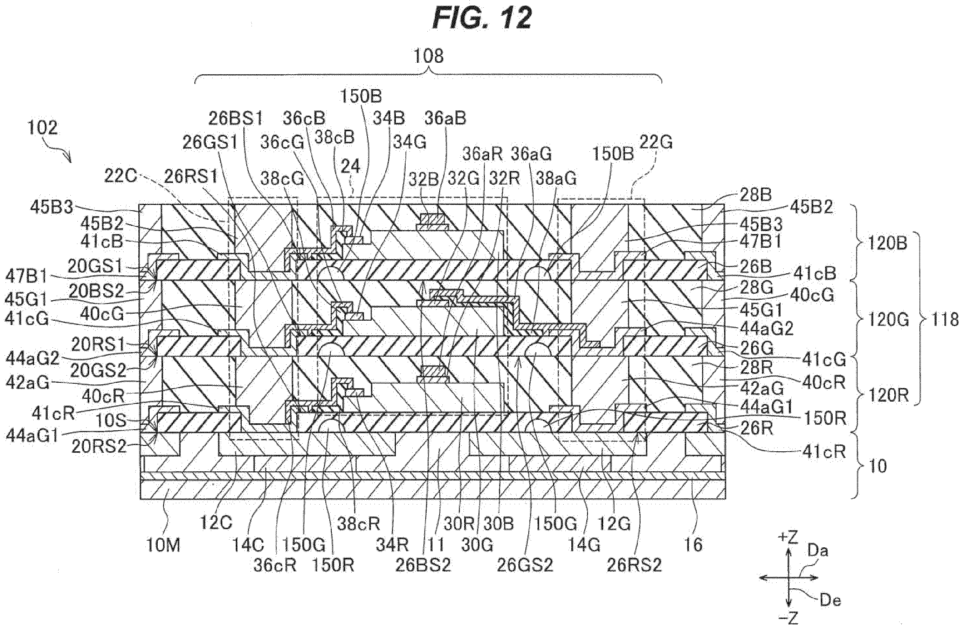

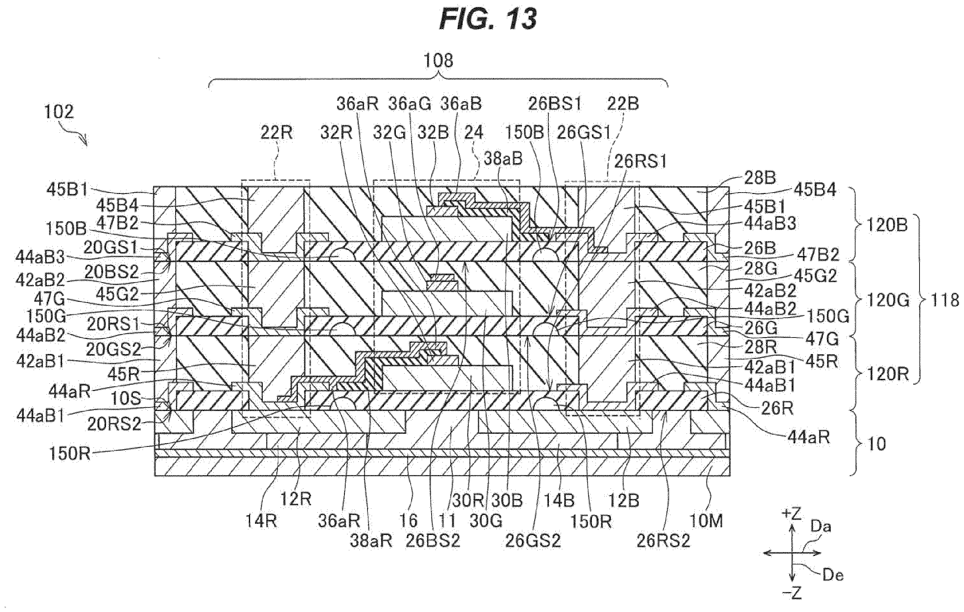

As illustrated in FIGs. 12 and 13, in which elements corresponding to those in FIGs. 4 and 5 are given the same reference characters, the LED display portion 102 of the second embodiment is different from the LED display portion 2 in having a thin-film layer group 118 instead of the thin-film layer group 18, but otherwise formed in the same manner. As illustrated in FIGs. 11 to 13, the LED display portion 102 includes multiple pixel portions 108 each corresponding to one pixel.

### <2-3. Configuration of thin-film layer group>

The thin-film layer group 118 of the second embodiment is different from the thin-film layer group 18 in having a first thin-film layer 120R, a second thin-film layer 120G, and a third thin-film layer 120B instead of the first thin-film layer 20R, second thin-film layer 20G, and third thin-film layer 20B, but otherwise formed in the same manner. Hereinafter, the first thin-film layer 120R, second thin-film layer 120G, and third thin-film layer 120B may also be referred to collectively as thin-film layers 120.

### <2-3-1. Configuration of first thin-film layers

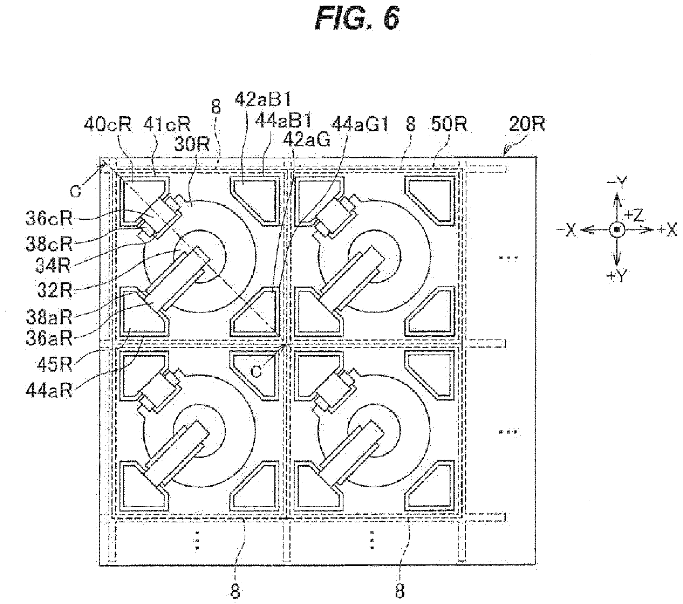

As illustrated in FIGs. 11, 12, and 13, and FIG. 14, in which elements corresponding to those in FIG. 6 are given the same reference characters, the first thin-film layer 120R of the second embodiment is different from the first thin-film layer 20R in having an air passage groove 150R instead of the air passage groove 50R, but otherwise formed in the same manner.

### <2-3-2. Configuration of air passage groove>

The air passage groove 150R is formed in the entire region of the base layer lower surface 26RS2 such that it has a semicircular transverse cross-section, and is recessed in the +Z direction, in the same manner as the air passage groove 50R. Thus, while the portion of the base layer lower surface 26RS2 (or first thin-film layer lower surface 20RS2) in which the air passage groove 150R is not formed is in contact with the substrate surface 10S, the portion of the base layer lower surface 26RS2 (or first thin-film layer lower surface 20RS2) in which the air passage groove 150R is formed is not in contact with the substrate surface 10S, and forms a gap with the substrate surface 10S. The air passage groove 150R is constituted by multiple groove portions connected to each other over the entire region of the base layer lower surface 26RS2, and has ends in the X and Y directions, which are located at end surfaces of the base layer 26R in the X and Y directions. Thus, similarly to the air passage groove 50R, the air passage groove 150R communicates with the outside of the base layer 26R through air passage openings (or vents) having semicircular shapes and formed in the end surfaces of the base layer 26R in the X and Y directions, which allows air in the air passage groove 150R to be discharged to the outside of the base layer 26R.

The air passage groove 150R is a combination of linear groove portions passing between the thin-film LEDs 30R and the vertical wirings 22B (or anode pads 44aB1) of the pixel portions 108 and between the thin-film LEDs 30R and the vertical wirings 22R (or anode pads 44aR) of the pixel portions 108 and extending in a direction inclined 45° to the +X direction in the +Y direction, and linear groove portions passing between the thin-film LEDs 30R and the vertical wirings 22G (or anode pads 44aG1) of the pixel portions 108 and between the thin-film LEDs 30R and the vertical wirings 22C (or cathode pads 41cR) of the pixel portions 108 and extending in a direction inclined 45° to the +X direction in the -Y direction, as viewed in the Z direction. Thus, the air passage groove 150R has a grid pattern having squares each surrounding one thin-film LED 30R, and squares each surrounding four vertical wirings 22C, 22R, 22G, and 22B (or cathode pad 41cR and anode pads 44aG1, 44aR, and 44aB1) surrounded by four thin-film LEDs 30R. Thus, in each pixel portion 108, the air passage groove 150R is located outside the thin-film LED 30R in the X and Y directions and inside the vertical wirings 22 in the X and Y directions, as viewed from the center of the pixel portion 108. Thus, the air passage groove 150R is located in a region that overlaps the lead-out wirings 36aR and 36cR and interlayer insulating films 38aR and 38cR but does not overlap the thin-film LEDs 30R, cathode pads 41cR, and anode pads 44aG1, 44aR, and 44aB1, as viewed in the Z direction. The air passage groove 150R can be said to extend in directions having components in the X and Y directions in which the multiple thin-film LEDs 30R are arranged.

A set of the three thin-film LEDs 30 of a pixel portion 108 may be referred to as a thin-film LED set, and a set of the four vertical wirings 22C, 22R, 22G, and 22B surrounded by four thin-film LED sets may be referred to as a vertical wiring set. The air passage groove 150R has cells (or squares) each surrounding one thin-film LED set and cells (or squares) each surrounding one vertical wiring set.

A height (or depth) of the air passage groove 150R in the Z direction is not more than half a height of the base layer 26R, and is uniform over the entire lower surface of the base layer 26R, similarly to the air passage groove 50R. As such, in the LED display device 101, the height of the air passage groove 150R is not too large. This ensures the strength of the base layer 26R. In the LED display device 101, to facilitate discharge of air between the base layer 26R and the substrate surface 10S to the outside, it is preferable to make the height of the air passage groove 150R large and make the area of the transverse cross-section as large as possible while ensuring the strength of the base layer 26R.

### <2-3-3. Configurations of second thin-film layer and air passage groove thereof>

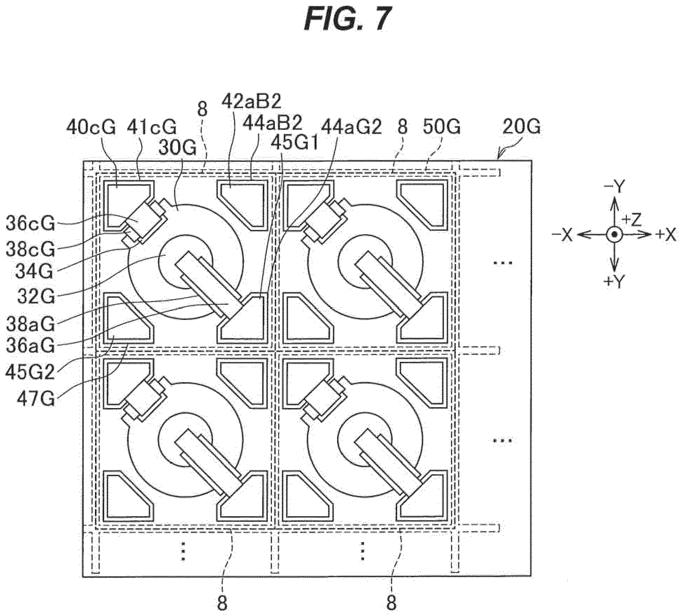

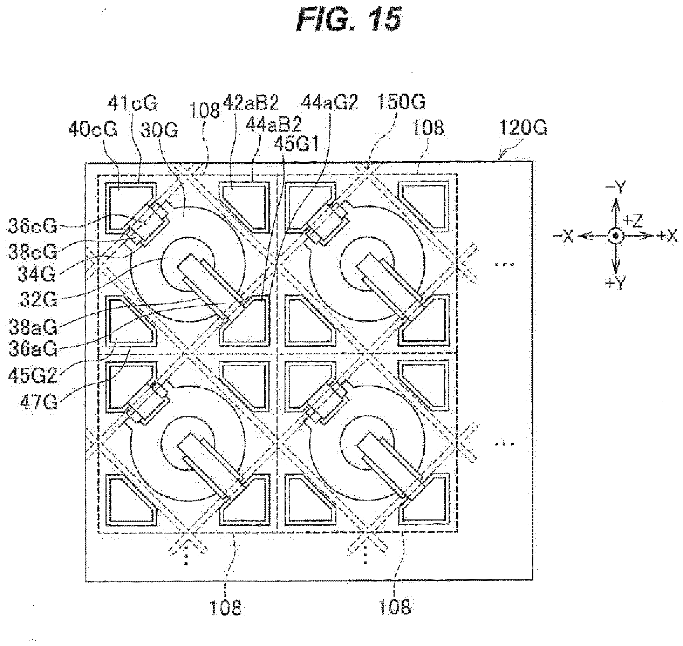

As illustrated in FIGs. 11, 12, and 13, and FIG. 15, in which elements corresponding to those in FIG. 7 are given the same reference characters, the second thin-film layer 120G of the second embodiment is different from the second thin-film layer 20G in having an air passage groove 150G instead of the air passage groove 50G, but otherwise formed in the same manner. The air passage groove 150G is formed in the base layer lower surface 26GS2 in the same manner as the air passage groove 150R of the base layer 26R. Specifically, the air passage groove 150G has the same shape as and coincides with the air passage groove 150R as viewed in the Z direction, and has the same height (or depth) in the Z direction as the air passage groove 150R.

### <2-3-4. Configurations of third thin-film layer and air passage groove thereof>

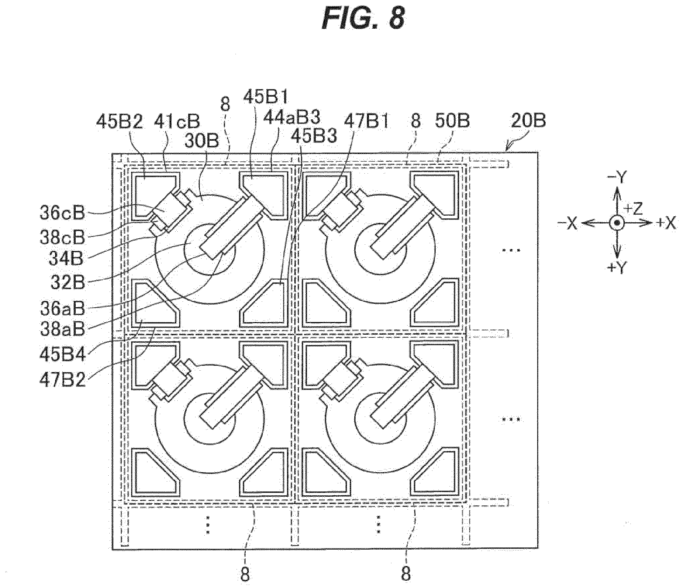

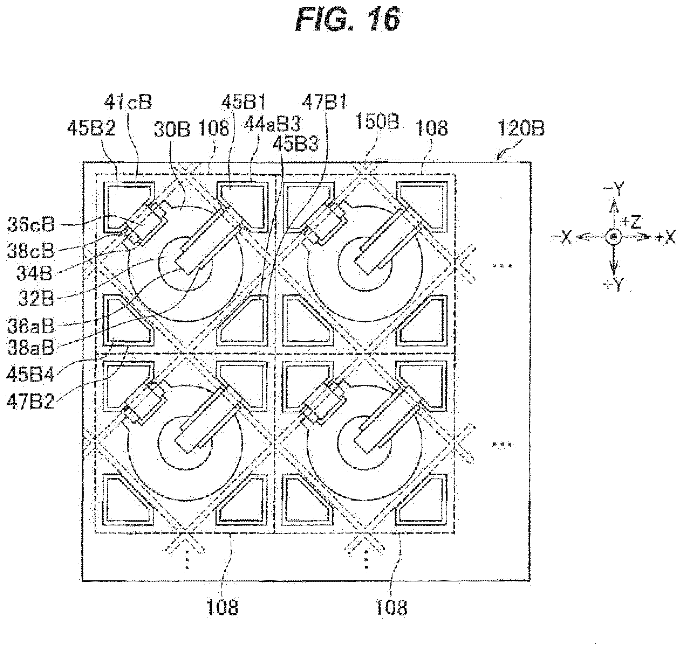

As illustrated in FIGs. 11, 12, and 13, and FIG. 16, in which elements corresponding to those in FIG. 8 are given the same reference characters, the third thin-film layer 120B of the second embodiment is different from the third thin-film layer 20B in having an air passage groove 150B instead of the air passage groove 50B, but otherwise formed in the same manner. The air passage groove 150B is formed in the base layer lower surface 26BS2 in the same manner as the air passage groove 150R of the base layer 26R and the air passage groove 150G of the base layer 26G. Specifically, the air passage groove 150B has the same shape as and coincides with the air passage grooves 150R and 150G as viewed in the Z direction, and has the same height (or depth) in the Z direction as the air passage grooves 150R and 150G. Hereinafter, the air passage grooves 150R, 150G, and 150B may also be referred to collectively as air passage grooves 150.

### <2-4. Method of manufacturing LED display portion>

A method of manufacturing the LED display portion 102 of the second embodiment is the same as the method of manufacturing the LED display portion 2 of the first embodiment (see FIGs. 9A to 9F and 10A to 10C).

### <2-5. Advantages>

The LED display device 101 according to the second embodiment can provide the same effects and advantages as the LED display device 1 according to the first embodiment.

### <3. Third embodiment>

### <3-1. Configuration of LED display device>

As illustrated in FIG. 1, an LED display device 201 according to a third embodiment is different from the LED display device 1 in having an LED display portion 202 instead of the LED display portion 2, but otherwise formed in the same manner. The LED display device 201 is a monochromatic display device in which a red LED element corresponds to one pixel.

### <3-2. Entire configuration of LED display portion>

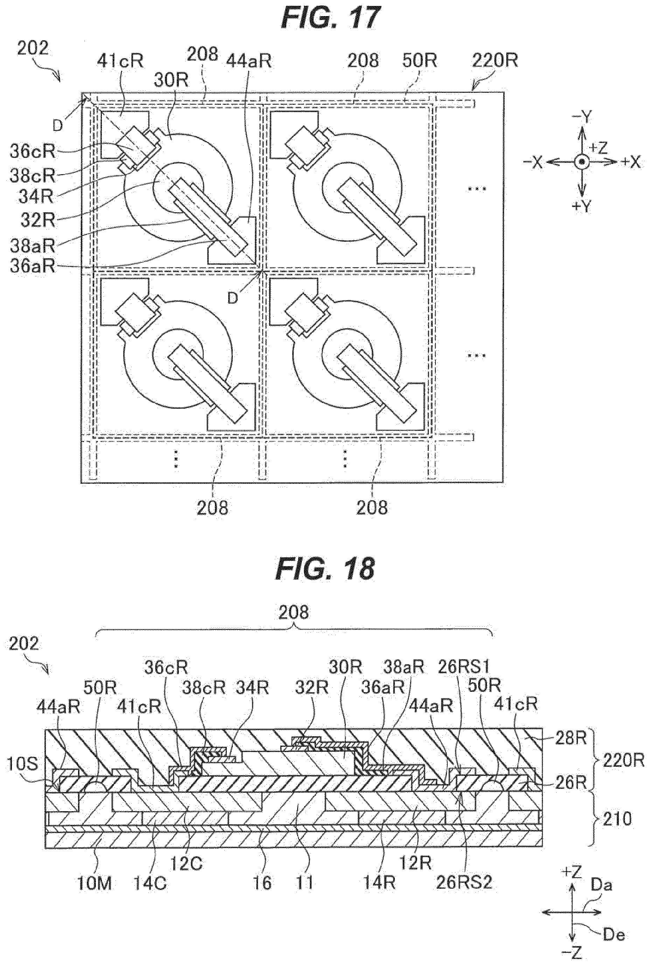

As illustrated in FIG. 17, in which elements corresponding to those in FIG. 6 are given the same reference characters, and FIG. 18, in which elements corresponding to those in FIGs. 4 and 5 are given the same reference characters, the LED display portion 202 of the third embodiment is different from the LED display portion 2 in having a circuit substrate 210 instead of the circuit substrate 10 and having a thin-film layer 220R instead of the thin-film layer group 18, but otherwise formed in the same manner. The LED display portion 202 has a single-layer structure having only the thin-film layer 220R. As illustrated in FIGs. 17 and 18, the LED display portion 202 includes multiple pixel portions 208 each corresponding to one pixel. The following describes the circuit substrate 210 and thin-film layer 220R of the LED display portion 202, focusing on one pixel or one pixel portion 208 as appropriate.

### <3-3. Configuration of circuit substrate>

The circuit substrate 210 is different from the circuit substrate 10 in that the circuit connection pads 12G and 12B and active elements 14G and 14B are omitted, and a circuit connection pad 12R and an active element 14R are located on the +X and +Y direction side of a thin-film LED 30R.

### <3-4. Configuration of thin-film layer>

The thin-film layer 220R is constituted by a base layer 26R, a cover layer 28R, the thin-film LED 30R, an anode electrode 32R, a cathode electrode 34R, lead-out wirings 36aR and 36cR, interlayer insulating films 38aR and 38cR, an anode pad 44aR, and cathode pad 41cR.

The base layer 26R and thin-film LED 30R are formed in the same manner as in the first thin-film layer 20R (see FIG. 4). The lead-out wiring 36aR is in contact with both an upper surface of the anode electrode 32R and the anode pad 44aR, and electrically connects them. The interlayer insulating film 38aR is formed by insulating material, is disposed between the lead-out wiring 36aR and the thin-film LED 30R, and is wider than the lead-out wiring 36aR as viewed in the Z direction. The interlayer insulating film 38aR prevents unwanted short-circuiting between the lead-out wiring 36aR and the thin-film LED 30R.

The lead-out wiring 36cR is in contact with both an upper surface of the cathode electrode 34R and the cathode pad 41cR, and electrically connects them. The interlayer insulating film 38cR is formed by insulating material similarly to the interlayer insulating film 38aR, is disposed between the lead-out wiring 36cR and the thin-film LED 30R, and is wider than the lead-out wiring 36cR as viewed in the Z direction. The interlayer insulating film 38cR prevents unwanted short-circuiting between the lead-out wiring 36cR and the thin-film LED 30R.

The anode pad 44aR is disposed at a position facing the circuit connection pad 12R of the circuit substrate 210 in the Z direction, and a lower surface of the anode pad 44aR is exposed from the base layer 26R. The cathode pad 41cR is disposed at a position facing the circuit connection pad 12C of the circuit substrate 210 in the Z direction, and a lower surface of the cathode pad 41cR is exposed from the base layer 26R.

The anode electrode 32R, cathode electrode 34R, lead-out wirings 36aR and 36cR, anode pad 44aR, and cathode pad 41cR are formed by conductive material, such as gold, copper, aluminum, or indium tin oxide. The interlayer insulating films 38aR and 38cR are preferably transparent to wavelengths of light emitted by the thin-film LED 30R.

The cover layer 28R is formed by, for example, the same transparent insulating material as the base layer 26R, has sufficient insulating properties, and is transparent at least to wavelengths of light emitted by the thin-film LED 30R.

The cover layer 28R is disposed to cover the base layer 26R, thin-film LED 30R, anode electrode 32R, cathode electrode 34R, lead-out wirings 36aR and 36cR, interlayer insulating films 38aR and 38cR, anode pad 44aR, and cathode pad 41cR from the +Z direction side. The thin-film LED 30R, anode electrode 32R, cathode electrode 34R, lead-out wirings 36aR and 36cR, interlayer insulating films 38aR and 38cR, anode pad 44aR, and cathode pad 41cR are embedded in between the cover layer 28R and the base layer 26R.

An upper surface of the thin-film layer 220R is an extremely smooth flat surface. Specifically, a surface roughness Rpv of the upper surface of the thin-film layer 220R (or the upper surface of the cover layer 28R) is 10 nm or less.

### <3-5. Configuration of air passage groove>

An air passage groove 50R is formed in the base layer lower surface 26RS2 in the same manner as in the first thin-film layer 20R (see FIGs. 4 and 6).

### <3-6. Method of manufacturing LED display portion>

A method of manufacturing the LED display portion 202 of the third embodiment is the same as the method of manufacturing the LED display portion 2 of the first embodiment (see FIGs. 9A to 9F and 10A to 10C) except that the process of stacking and bonding the second thin-film layer 20G and third thin-film layer 20B is omitted.

### <3-7. Advantages>

The LED display device 201 according to the third embodiment can provide the same effects and advantages as the LED display device 1 according to the first embodiment.

### <4. Fourth embodiment>

### <4-1. Configuration of LED display device>

As illustrated in FIG. 1, an LED display device 301 according to a fourth embodiment is different from the LED display device 201 in having an LED display portion 302 instead of the LED display portion 202, but otherwise formed in the same manner. The LED display device 301 is a monochromatic display device in which a red LED element corresponds to one pixel.

### <4-2. Entire configuration of LED display portion>

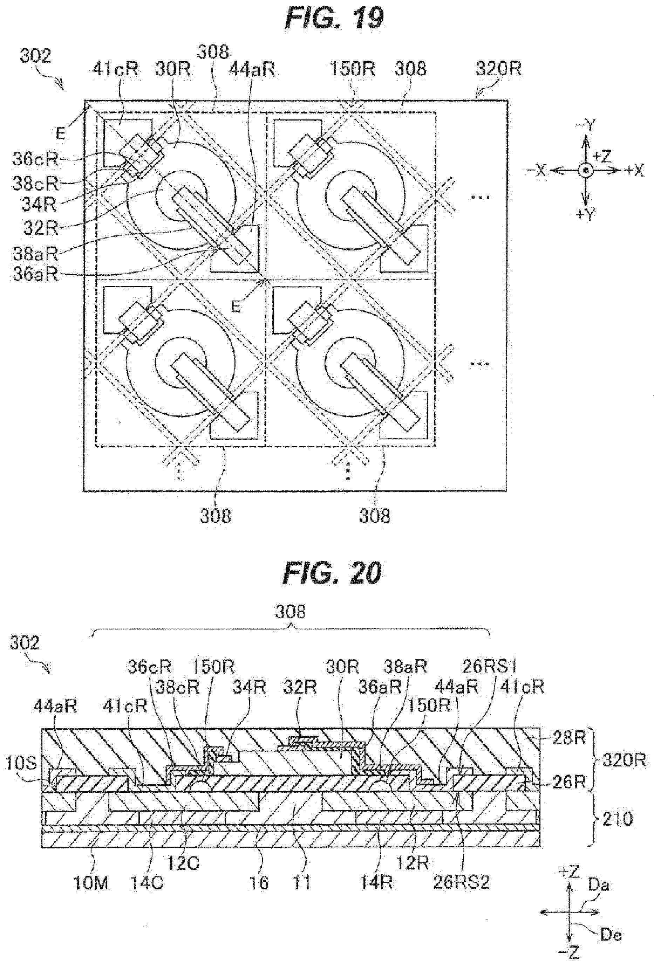

As illustrated in FIG. 19, in which elements corresponding to those in FIG. 17 are given the same reference characters, and FIG. 20, in which elements corresponding to those in FIG. 18 are given the same reference characters, the LED display portion 302 of the fourth embodiment is different from the LED display portion 202 in having a thin-film layer 320R instead of the thin-film layer 220R, but otherwise formed in the same manner. As illustrated in FIGs. 19 and 20, the LED display portion 302 includes multiple pixel portions 308 each corresponding to one pixel.

### <4-3. Configuration of thin-film layer>

The thin-film layer 320R of the fourth embodiment is different from the thin-film layer 220R in having an air passage groove 150R instead of the air passage groove 50R, but otherwise formed in the same manner. The air passage groove 150R is formed in the lower surface of the base layer 26R in the same manner as in the first thin-film layer 120R (see FIG. 12).

### <4-4. Method of manufacturing LED display portion>

A method of manufacturing the LED display portion 302 of the fourth embodiment is the same as the method of manufacturing the LED display portion 202 of the third embodiment.

### <4-5. Advantages>

The LED display device 301 according to the fourth embodiment can provide the same effects and advantages as the LED display device 201 according to the third embodiment.

### <5. Other embodiments>

In the first embodiment, the LED display device 1 includes the air passage groove 50R (see FIG. 6), which is disposed in a region outside (or that does not overlap) the thin-film LEDs 30R, cathode pads 41cR, and anode pads 44aG1, 44aR, and 44aB1 as viewed in the Z direction. However, this is not mandatory. In the LED display device 1, as viewed in the Z direction, as long as the air passage groove 50R is disposed in a region outside (or that does not overlap) the thin-film LEDs 30R, the air passage groove 50R may overlap at least part of the cathode pads 41cR, anode pads 44aG1, 44aR, and 44aB1. The same applies to the second thin-film layer 20G and third thin-film layer 20B. The same applies to the second to fourth embodiments.

In the first embodiment, in the LED display device 1, the air passage groove 50R (see FIGs. 4, 5, and 6) communicates with the outside of the base layer 26R. However, this is not mandatory. In the LED display device 1, the air passage groove 50R need not necessarily communicate with the outside of the base layer 26R. Also in this case, when the base layer 26R is bonded to the circuit substrate 10, it is possible to disperse air, preventing a mass of air from locally remaining between the base layer 26R and the circuit substrate 10. The same applies to the second thin-film layer 20G and third thin-film layer 20B. The same applies to the second to fourth embodiments.

In the first embodiment, in the LED display device 1, the air passage groove 50R (see FIGs. 4, 5, and 6) communicates with the outside of the base layer 26R at the end surfaces of the base layer 26R in the X and Y directions. However, this is not mandatory. In the LED display device 1, the air passage groove 50R may communicate with the outside of the first thin-film layer 20R at other various portions. For example, hole(s) may be provided from the upper surface of the third thin-film layer 20B to the air passage groove 50R in the -Z direction between adjacent pixel portions 8. The same applies to the second thin-film layer 20G and third thin-film layer 20B. The same applies to the second to fourth embodiments.

In the first embodiment, in the LED display device 1, the air passage grooves 50 are provided in the thin-film layer lower surfaces 20S2 (i.e., the first thin-film layer lower surface 20RS2, second thin-film layer lower surface 20GS2, and third thin-film layer lower surface 20BS2) of all the thin-film layers 20. However, this is not mandatory. In the LED display device 1, the air passage groove(s) 50 of some of the first thin-film layer lower surface 20RS2, second thin-film layer lower surface 20GS2, and third thin-film layer lower surface 20BS2 may be omitted. For example, it is possible that only the air passage groove 50R of the first thin-film layer 20R is provided, and the air passage groove 50G of the second thin-film layer 20G and the air passage groove 50B of the third thin-film layer 20B are omitted. The same applies to the second embodiment. In particular, in the LED display device 1, when a bonding object is grown on an upper surface of a bonded object instead of being bonded to the upper surface of the bonded object, an air passage groove 50 need not necessarily be formed in a lower surface of the bonding object facing the upper surface of the bonded object.

In the first embodiment, in the LED display device 1, the air passage grooves 50 of the first thin-film layer lower surface 20RS2, second thin-film layer lower surface 20GS2, and third thin-film layer lower surface 20BS2 have the same heights in the Z direction. However, this is not mandatory. In the LED display device 1, the air passage grooves 50 of the thin-film layer lower surfaces 20S2 (i.e., the first thin-film layer lower surface 20RS2, second thin-film layer lower surface 20GS2, and third thin-film layer lower surface 20BS2) may have different heights. The same applies to the second embodiment.

In the first embodiment, in the LED display device 1, in each thin-film layer lower surface 20S2, the height of the entire air passage groove 50 in the Z direction is uniform. However, this is not mandatory. In the LED display device 1, in each thin-film layer lower surface 20S2, the height of the air passage groove 50 in the Z direction may vary in the X and Y directions. The same applies to the second to fourth embodiments.

In the first embodiment, in the LED display device 1, the air passage grooves 50 have grid patterns as viewed in the Z direction. However, this is not mandatory. In the LED display device 1, the air passage grooves 50 may have other various arrangements as viewed in the Z direction. For example, each air passage groove 50 may consist of only one or more linear groove portions along the X direction or only one or more linear groove portions along the Y direction. The same applies to the second to fourth embodiments.

In the first embodiment, in the LED display device 1, the air passage grooves 50 have semicircular transverse cross-sections. However, this is not mandatory. In the LED display device 1, the air passage grooves 50 may have transverse cross-sections having other various shapes. The same applies to the second to fourth embodiments.

In the first embodiment, in the LED display device 1, the air passage grooves 50R, 50G, and 50B have the same shape and coincide as viewed in the Z direction. However, this is not mandatory. In the LED display device 1, the air passage grooves 50R, 50G, and 50B may have different shapes as viewed in the Z direction. The same applies to the second embodiment.

In the first embodiment, in the LED display device 1, for each air passage groove 50, after the bonding object is stacked and bonded to the bonded object, part or the whole of the air passage groove 50 may be filled with a filler. For example, it is possible to fill part or the whole of the air passage groove 50 with resin and harden or cure the resin. For example, it is possible to fill the air passage groove 50 with a material or a raw material thereof in the form of liquid, through the air passage opening(s) from the outside by using capillary action, and harden or cure the material. The material may be a transparent insulating material, which may include an organic insulating material, such as polyimide resin, epoxy resin, or acrylic resin, or an inorganic insulating material, such as SiO₂ or SiN. It is also possible to supply the air passage groove 50 with a material or a raw material thereof in the form of gas, through the air passage opening(s) from the outside and deposit a solid material by using vapor phase growth. The same applies to the second to fourth embodiments.

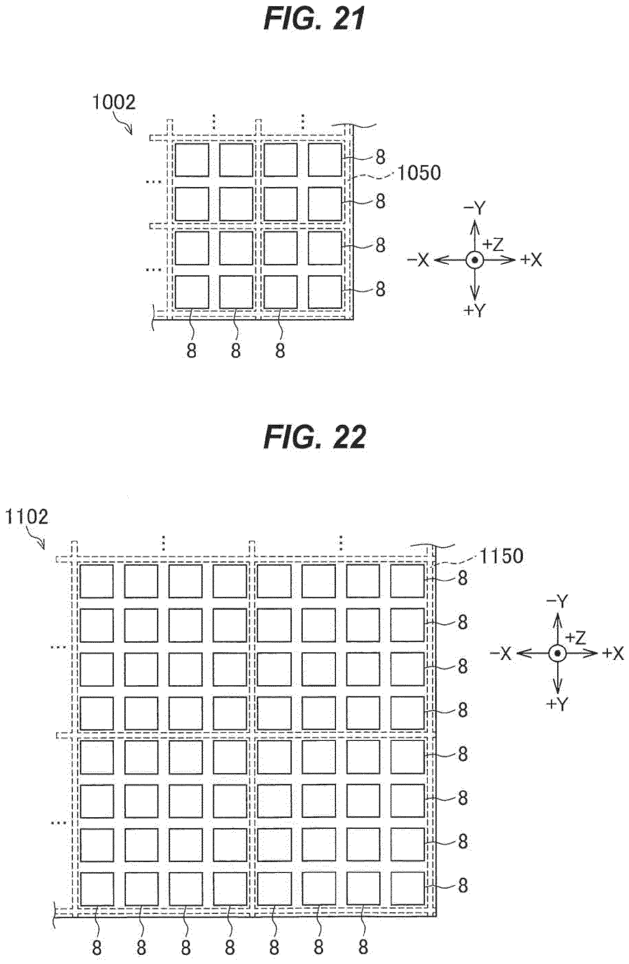

In the first embodiment, in the LED display device 1, each air passage groove 50 (see FIG. 2) is arranged to surround the pixel portions 8 one by one. However, this is not mandatory. In the LED display device 1, each air passage groove may be arranged to surround the pixel portions 8 in sets of two or more. For example, as in an LED display portion 1002 illustrated in FIG. 21, in which elements corresponding to those in FIG. 2 are given the same reference characters, an air passage groove 1050 may be arranged to surround the pixel portions 8 in sets of four. As in an LED display portion 1102 illustrated in FIG. 22, in which elements corresponding to those in FIG. 2 are given the same reference characters, an air passage groove 1150 may be arranged to surround the pixel portions 8 in sets of 16. The same applies to the third embodiment.

In the first embodiment, in the LED display device 1, in each thin-film layer lower surface 20S2, all the groove portions of the air passage groove 50 are connected together. However, this is not mandatory. In the LED display device 1, for each thin-film layer lower surface 20S2, it is possible that the thin-film layer lower surface 20S2 is divided into multiple blocks, such as two blocks consisting of a half on the +X direction side and a half on the -X direction side, or four blocks, and the air passage groove 50 includes multiple groove portions connected together in each block. The groove portions of the air passage groove 50 may be connected together between the blocks. The same applies to the second to fourth embodiments.

In the first embodiment, in the LED display device 1, the thin-film layer group 18 has a layered structure in which three layers, the first thin-film layer 20R, second thin-film layer 20G, and third thin-film layer 20B, are stacked. However, this is not mandatory. In the LED display device 1, one, two, or four or more thin-film layers 20 may be provided instead of three thin-film layers 20. For example, the thin-film layer group 18 may be one for two-color display having a layered structure with two thin-film layers 20 stacked, or may have a single-layer structure having only one thin-film layer 20 as in the third embodiment. The same applies to the second embodiment.

In the first embodiment, in the LED display device 1, the circuit substrate 10 is an active matrix circuit substrate. However, this is not mandatory. In the LED display device 1, the circuit substrate 10 may be a passive matrix circuit substrate. The same applies to the second to fourth embodiments.

In the first embodiment, in the LED display device 1, as illustrated in FIGs. 10A to 10C, the manufacturing apparatus 60 separates the first thin-film layer 20R from the formation substrate 68R by etching and removing the sacrificial layer 70R (see FIG. 9F), bonds the first thin-film layer 20R to the upper surface of the circuit substrate 10 by means of intermolecular force, separates the second thin-film layer 20G from the formation substrate 68G by etching and removing the sacrificial layer (not illustrated) for the second thin-film layer 20G, bonds the second thin-film layer 20G to the upper surface of the first thin-film layer 20R bonded to the circuit substrate 10 by means of intermolecular force, separates the third thin-film layer 20B from the formation substrate 68B by etching and removing the sacrificial layer (not illustrated) for the third thin-film layer 20B, and bonds the third thin-film layer 20B to the upper surface of the second thin-film layer 20G bonded to the first thin-film layer 20R by means of intermolecular force, thereby stacking the first thin-film layer 20R, second thin-film layer 20G, and third thin-film layer 20B on the circuit substrate 10. However, this is not mandatory. The manufacturing apparatus 60 may separate the second thin-film layer 20G from the formation substrate 68G by etching and removing the sacrificial layer (not illustrated) for the second thin-film layer 20G, bond the second thin-film layer 20G to the upper surface of the first thin-film layer 20R on the formation substrate 68R and sacrificial layer 70R by means of intermolecular force, separate the third thin-film layer 20B from the formation substrate 68B by etching and removing the sacrificial layer (not illustrated) for the third thin-film layer 20B, bond the third thin-film layer 20B to the upper surface of the second thin-film layer 20G bonded to the first thin-film layer 20R by means of intermolecular force, separate the first thin-film layer 20R, second thin-film layer 20G, and third thin-film layer 20B from the formation substrate 68R by etching and removing the sacrificial layer 70R (see FIG. 9F), and bond the first thin-film layer 20R, second thin-film layer 20G, and third thin-film layer 20B to the upper surface of the circuit substrate 10 by means of intermolecular force, thereby stacking the first thin-film layer 20R, second thin-film layer 20G, and third thin-film layer 20B on the circuit substrate 10. The same applies to the second embodiment.

In the first embodiment, in the LED display device 1, the dummy pillars 45R, 45G1, 45G2, 45B1, 45B2, 45B3, and 45B4, and dummy pads 47G, 47B1, and 47B2 are provided, ensuring structural symmetry of the pixel portions 8 and heat dissipation. However, this is not mandatory. In the LED display device 1, at least some of the dummy pillars 45R, 45G1, 45G2, 45B1, 45B2, 45B3, and 45B4, and dummy pads 47G, 47B1, and 47B2 may be omitted.

In the first embodiment, in the LED display device 1, in the first thin-film layer 20R, the vertical wirings 22 are constituted by the cathode pad 41cR and anode pads 44aG1, 44aR, and 44aB1, which are pad members serving as connections, and the cathode pillar 40cR, dummy pillar 45R, and anode pillars 42aG and 42aB1, which are pillar members serving as electrode pillars. However, this is not mandatory. In the LED display device 1, for each vertical wiring 22, a pad member and a pillar member may be formed in the form of a single body as the vertical wiring 22 serving as a connection. The pad member and pillar member can be formed by various conductive materials. In this case, the air passage groove 50R may be formed outside the vertical wirings 22 in the base layer lower surface 26RS2 as viewed in the Z direction. The same applies to the second thin-film layer 20G and third thin-film layer 20B. The same applies to the second embodiment.

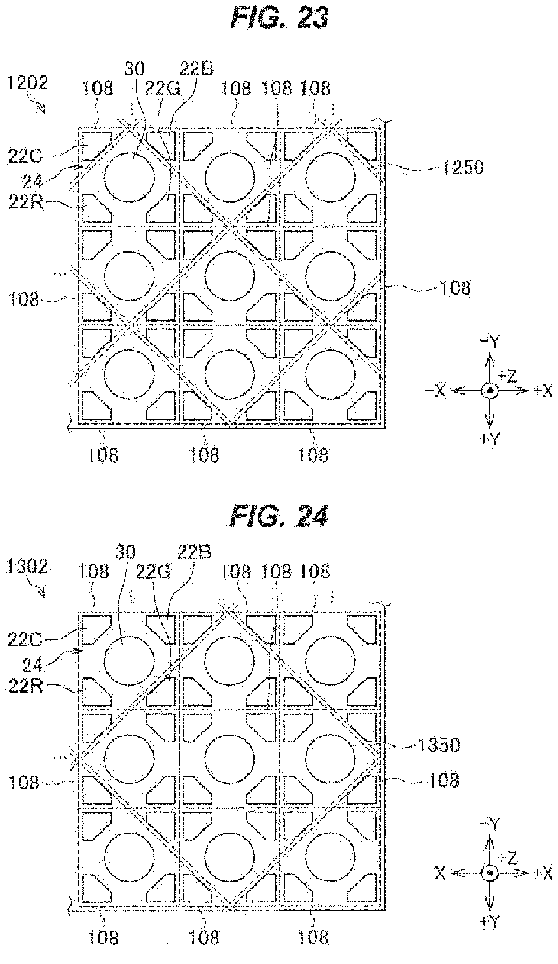

In the second embodiment, in the LED display device 101, the air passage grooves 150 (see FIG. 11) are disposed to pass between the thin-film LEDs 30 of all the pixel portions 8 and all the vertical wirings 22. However, this is not mandatory. In the LED display device 101, each air passage groove may be constituted by multiple groove portions arranged at other various intervals. For example, each air passage groove may be disposed as illustrated in FIG. 23, in which elements corresponding to those in FIG. 11 are given the same reference characters. In FIG. 23, an air passage groove 1250 of an LED display portion 1202 is constituted by linear groove portions in the same manner as each air passage groove 150 (see FIG. 11) except that the linear groove portions are arranged at intervals equal to twice those in each air passage groove 150. In this case, the air passage groove 1250 has cells each surrounding two thin-film LED sets and two vertical wiring sets. For example, the air passage groove 1250 has cells each surrounding two thin-film LED sets arranged in the Y direction and two vertical wiring sets arranged in the X direction. Also, each air passage groove may be disposed as illustrated in FIG. 24, in which elements corresponding to those in FIG. 11 are given the same reference characters. In FIG. 24, an air passage groove 1350 of an LED display portion 1302 is constituted by linear groove portions in the same manner as each air passage groove 150 (see FIG. 11) except that the linear groove portions are arranged at intervals equal to three times those in each air passage groove 150. In this case, the air passage groove 1350 has cells each surrounding five thin-film LED sets and four vertical wiring sets and cells each surrounding four thin-film LED sets and five vertical wiring sets. The same applies to the fourth embodiment.

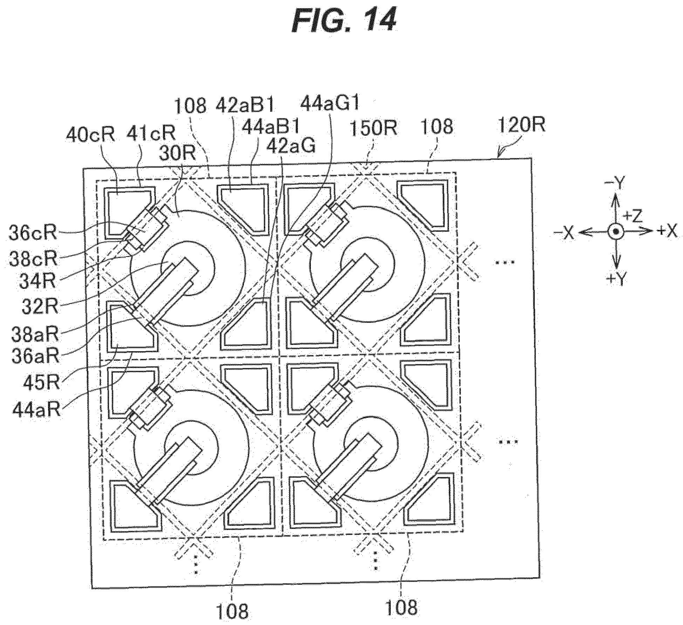

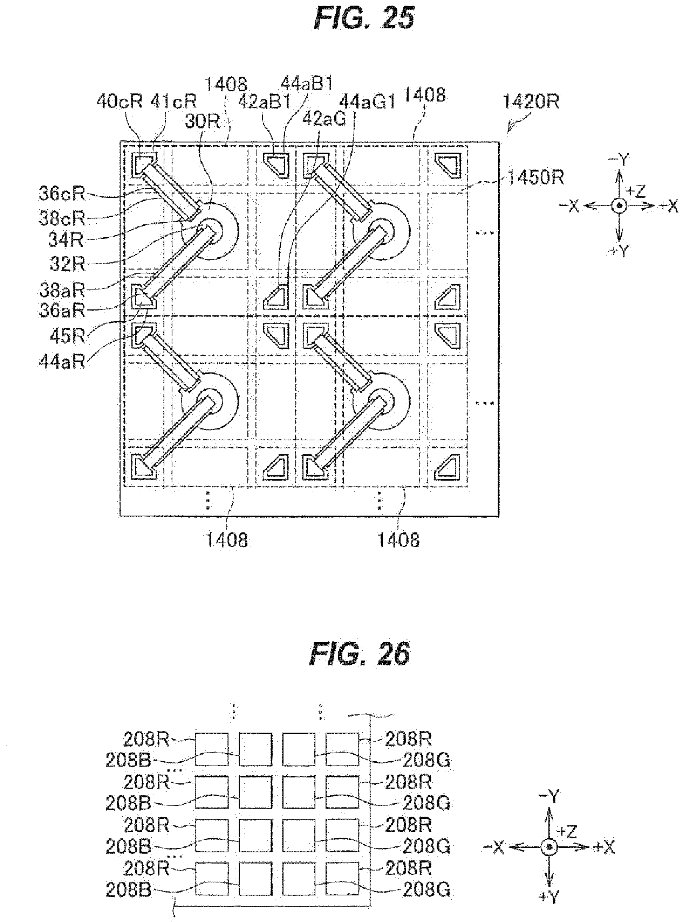

In the second embodiment, in the LED display device 101, each air passage groove 150 (see FIG. 11) is disposed such that the linear groove portions are inclined 45° to the X and Y directions and pass between the thin-film LEDs 30 of all the pixel portions 108 and all the vertical wirings 22. However, this is not mandatory. For example, in the LED display device 101, the air passage groove 150R may be disposed as illustrated in FIG. 25, in which elements corresponding to those in FIG. 14 are given the same reference characters. In FIG. 25, an air passage groove 1450R of a first thin-film layer 1420R is constituted by linear groove portions extending at least substantially parallel to the X and Y directions and passing between the thin-film LEDs 30R of all the pixel portions 1408 and all the vertical wirings 22 (or the cathode pads 41cR, and anode pads 44aG1, 44aR, and 44aB1). The same applies to the second thin-film layer 120G and third thin-film layer 120B.

In the third embodiment, the LED display device 201 is a monochromatic display device in which the pixel portions 208 of the red thin-film layer 220R are arranged in a single-layer structure on the upper surface of the circuit substrate 210, and each red LED element corresponds to one pixel. However, this is not mandatory. As illustrated in FIG. 26, the LED display device 201 may be a full-color display device in which pixel portions 208R of red thin-film layers, pixel portions 208G of green thin-film layers, and pixel portions 208B of blue thin-film layers are arranged in order in a single-layer structure on the upper surface of the circuit substrate 210. The same applies to the fourth embodiment.

In the first embodiment, the present disclosure is applied to the LED display device 1, which is a direct-view display. However, this is not mandatory. The present disclosure may be applied to displays used as projectors or light sources. The same applies to the second to fourth embodiments.

In the first embodiment, the multiple thin-film LEDs 30R are disposed on the base layer 26R. However, it is possible that only one thin-film LED 30R is disposed on the base layer 26R. The same applies to the second thin-film layer 120G and third thin-film layer 120B. The same applies to the second to fourth embodiments.

In the above embodiments, the thin-film LEDs 30 are used as semiconductor elements. However, this is not mandatory. Other various semiconductor elements, such as photodiodes or transistors, may be used as semiconductor elements. Thus, although in the above embodiments, the LED display devices 1, 101, 201, and 301 are used as semiconductor devices, the scope of the present disclosure covers semiconductor devices including the above various semiconductor elements.

The present disclosure is not limited to the above embodiments. Specifically, the scope of the present disclosure covers embodiments obtained by arbitrarily combining some or all of the above embodiments. Also, the scope of the present disclosure covers embodiments obtained by extracting part of the configuration described in one of the above embodiments and replacing part of the configuration of another of the above embodiments with the extracted part, and embodiments obtained by extracting part of the configuration described in one of the above embodiments and adding the extracted part to another of the above embodiments.

In the first embodiment, the LED display device 1 as a semiconductor device is constituted by the base layer 26R as a planarized layer, the thin-film LEDs 30R as semiconductor elements, the cathode pads 41cR and anode pads 44aG1, 44aR, and 44aB1 as connections, and the air passage groove 50R as a groove. However, the present disclosure is not limited to this. Semiconductor devices may be constituted by planarized layers, semiconductor elements, connections, and grooves that have other various configurations.

The present disclosure is applicable to, for example, LED displays with multiple LEDs arranged therein.

## Claims

1. A semiconductor device (1, 101, 201, 301) comprising:
a first planarized layer (26R) having insulating properties, the first planarized layer (26R) having a first surface (26RS1) and a second surface (26RS2) opposite the first surface (26RS1);
a plurality of first semiconductor elements (30R) formed on the first surface (26RS1) of the first planarized layer (26R); and
a first groove (50R, 150R) provided in the second surface (26RS2) of the first planarized layer (26R),
wherein the first groove (50R, 150R) is formed in a region outside the plurality of first semiconductor elements (30R) as viewed in a first direction (De) perpendicular to the first surface (26RS1).

2. The semiconductor device (1, 101, 201, 301) of claim 1, further comprising a plurality of first connections (41cR, 44aG1, 44aR, 44aB1) connected to the plurality of first semiconductor elements (30R);
wherein the first groove (50R, 150R) is formed in a region outside the plurality of first semiconductor elements (30R) and the plurality of first connections (41cR, 44aGl, 44aR, 44aB1) as viewed in the first direction (De).

3. The semiconductor device (1, 101, 201, 301) of claim 2, wherein the plurality of first connections (41cR, 44aG1, 44aR, 44aB1) are exposed in the second surface (26RS2) of the first planarized layer (26R), and electrically connect the plurality of first semiconductor elements (30R) to a plurality of other connections (12C, 12G, 12R, 12B) located on a second surface side of the first planarized layer (26R).

4. The semiconductor device (1, 101, 201, 301) of any one of claims 1 to 3, wherein the first groove (50R, 150R) communicates with an outside of the first planarized layer (26R) at an end surface of the first planarized layer (26R) in a surface direction along the first surface (26RS1).

5. The semiconductor device (1, 101, 201, 301) of any one of claims 1 to 4, wherein the first groove (50R, 150R) is formed outside at least the plurality of first semiconductor elements (30R) to surround the plurality of first semiconductor elements (30R), as viewed in the first direction (De).

6. The semiconductor device (1, 101, 201, 301) of claim 2 or 3, wherein the first groove (50R, 150R) is formed outside the plurality of first connections (41cR, 44aG1, 44aR, 44aB1) to surround the plurality of first semiconductor elements (30R) and the plurality of first connections (41cR, 44aG1, 44aR, 44aB1), as viewed in the first direction (De).

7. The semiconductor device (1, 101, 201, 301) of any one of claims 1 to 6, wherein the first groove (50R, 150R) has a grid pattern as viewed in the first direction (De).

8. The semiconductor device (1, 101, 201, 301) of any one of claims 1 to 7, wherein the first groove (50R, 150R) extends in a direction having a component in a direction in which the plurality of first semiconductor elements (30R) are arranged.

9. The semiconductor device (1, 101, 201, 301) of any one of claims 1 to 8, wherein a depth of the first groove (50R, 150R) in the first direction (De) is not more than half a thickness of the first planarized layer (26R) in the first direction (De).

10. The semiconductor device (1, 101, 201, 301) of any one of claims 1 to 9, wherein the first groove (50R, 150R) is recessed from the second surface (26RS2) toward the first surface (26RS1) in the second surface (26RS2) of the first planarized layer (26R).

11. The semiconductor device (1, 101) of any one of claims 2, 3 and 6, comprising:
a first layer (20R) including the first planarized layer (26R), the plurality of first semiconductor elements (30R), the plurality of first connections (41cR, 44aG1, 44aR, 44aB1), and the first groove (50R, 150R);
a substrate (10) on which the first layer (20R) is stacked such that the second surface (26RS2) of the first planarized layer (26R) is in contact with the substrate (10);
a second layer (20G) stacked on a surface of the first layer (20R) opposite the substrate (10) and including at least one second semiconductor element (30G); and
a third layer (20B) stacked on a surface of the second layer (20G) opposite the first layer (20R) and including at least one third semiconductor element (30B).

12. The semiconductor device (1, 101) of claim 11, wherein
the at least one second semiconductor element (30G) comprises a plurality of second semiconductor elements (30G),
the at least one third semiconductor element (30B) comprises a plurality of third semiconductor elements (30B),
the second layer (20G) includes:
a second planarized layer (26G) having insulating properties, the second planarized layer (26G) being in contact with the first layer (20R), the second planarized layer (26G) having a first surface (26GS1) on a third layer side and a second surface (26GS2) opposite the first surface (26GS1) of the second planarized layer (26G);
the plurality of second semiconductor elements (30G) formed on the first surface (26GS1) of the second planarized layer (26G);
a plurality of second connections (41cG, 44aG2, 47G, 44aB2) connected to the plurality of second semiconductor elements (30G); and
a second groove (50G, 150G) provided in the second surface (26GS2) of the second planarized layer (26G),
the third layer (20B) includes:
a third planarized layer (26B) having insulating properties, the third planarized layer (26B) being in contact with the second layer (20G), the third planarized layer (26B) having a first surface (26BS1) opposite the second layer (20G) and a second surface (26BS2) opposite the first surface (26BS1) of the third planarized layer (26B);
the plurality of third semiconductor elements (30B) formed on the first surface (26BS1) of the third planarized layer (26B);
a plurality of third connections (41cB, 4781, 4782, 44aB3) connected to the plurality of third semiconductor elements (30B); and
a third groove (50B, 150B) provided in the second surface (26BS2) of the third planarized layer (26B),
the second groove (50G, 150G) is formed in a region outside the plurality of second semiconductor elements (30G) as viewed in the first direction (De), and
the third groove (50B, 150B) is formed in a region outside the plurality of third semiconductor elements (30B) as viewed in the first direction (De).

13. The semiconductor device (1, 101) of claim 12, wherein the first groove (50R, 150R), the second groove (50G, 150G), and the third groove (50B, 150B) are formed in a region outside the plurality of first semiconductor elements (30R), the plurality of second semiconductor elements (30G), and the plurality of third semiconductor elements (30B) as viewed in the first direction (De).

14. The semiconductor device (1, 101, 201, 301) of any one of claims 1 to 13, wherein the plurality of first semiconductor elements (30R) are light emitting elements.

15. An LED display device comprising the semiconductor device (1, 101, 201, 301) of claim 14.

16. A method of manufacturing a semiconductor device, the method comprising:
forming, on a formation substrate (68R), a sacrificial layer (70R) having a projection (72R) in a surface of the sacrificial layer (70R) opposite a surface of the sacrificial layer (70R) in contact with the formation substrate (68R);
forming, on the sacrificial layer (70R), a planarized layer (26R) having insulating properties, the planarized layer (26R) having a first surface (26RS1) and a second surface (26RS2) opposite the first surface (26RS1);
forming, on the first surface (26RS1) of the planarized layer (26R), a plurality of semiconductor elements (30R); and
forming a groove (50R, 150R) in the second surface (26RS2) of the planarized layer (26R) by removing the sacrificial layer (70R),
wherein the projection (72R) is located in a region outside the plurality of semiconductor elements (30R) as viewed in a direction (De) perpendicular to the first surface (26RS1) .
